(19) Europäisches Patentamt
European Patent Office
Office européen des brevets

(11) **EP 1 054 514 B1**

(12) **EUROPEAN PATENT SPECIFICATION**

(45) Date of publication and mention
of the grant of the patent:
**26.09.2007 Bulletin 2007/39**

(51) Int Cl.:
*H03M 7/00* *(2006.01)* *H04N 7/26* *(2006.01)*

(21) Application number: **99870108.0**

(22) Date of filing: **21.05.1999**

(54) **Method and apparatus for the compression and/or transport and/or decompression of a digital signal**

Verfahren und Vorrichtung zur Komprimierung und/oder Übertragung und/oder Dekomprimierung eines digitalen Signals

Méthode et dispositif de compression et/ou transport et/ou décompression d'un signal numérique

(84) Designated Contracting States:
**AT BE CH DE DK ES FI FR GB GR IE IT LI LU NL PT SE**

(43) Date of publication of application:
**22.11.2000 Bulletin 2000/47**

(73) Proprietor: **Scientific-Atlanta Europe**
**8500 Kortrijk (BE)**

(72) Inventor: **De Lameilleure, Jan**
**8500 Kortrijk (BE)**

(74) Representative: **Bird, Ariane et al**
**Bird Goën & Co**
**Klein Dalenstraat 42A**
**3020 Winksele (BE)**

(56) References cited:
**EP-A- 0 361 761** **WO-A-97/21274**
**US-A- 4 791 483** **US-A- 5 592 161**

• **HARTWIG S ET AL: "DIGITALE BILDCODIERUNG (TEIL 9). \DIGITALES FERNSEHEN: VOM LABOR ZUM STANDARD" FERNSEH UND KINOTECHNIK, vol. 46, no. 10, 1 October 1992 (1992-10-01), pages 687-696, XP000315576 ISSN: 0015-0142**

## Description

### Technical field of the invention

The present invention relates to methods and to apparatuses for the compression and/or transport and/or decompression of digital signals, and for the compression and/or transport and/or decompression of digitised television IF (Intermediate Frequency) signals in particular. The primary field of application is that of cable television systems.

### State of the art

Methods and apparatuses are known for the transport of television signals over analog communication paths as, e.g., cable television networks, whereby television signals are transported as analog IF signals or modulated analog IF signals, the signals having a format according to one of the existing transmission standards as mentioned in ITU-R Recommendation 470-2, "Television Systems", 1986.

Methods are known to digitise IF signals. EP-0749237 and EP-0763899 of THOMSON multimedia S.A. describe such methods.

Methods are known to transport an uncompressed digitised television IF signal over a transport channel. In the Proceedings of the International TV Symposium, pp. 709-717, Montreux 1997, F. Van de Vyver, "BARCO Lynx: Digital Optical Solution for IF Transport of Television Signals", a method is described for transport of a digitised television IF signal over an optical fibre.

Methods are known to compress and transport digital signals, including digitised baseband audio and/or video signals. In television systems with digital compression and transport, these methods are used to compress audio and video separately before being multiplexed into one bit-stream of compressed data. For coloured video, the bit-stream is in its turn a multiplex of occasional motion information and separately compressed components (e.g., luminance and colour differences).

However, in case of a digitised television IF signal, which is a sampled carrier modulated by the composite signal of audio and all video components, both audio and video components are completely merged, making separate compression of each of them impossible. Therefore, typical compression techniques for video and audio cannot be used for the compression and/or transport of digitised television IF signals.

When a low implementation complexity and a lossless or nearly lossless compression are required, the compression ratio cannot be high. A possible choice is a split of the input in LSB's (Least Significant Bits) which are not compressed and MSB's (Most Significant Bits) which are compressed with predictive coding. In predictive coding, samples are coded one by one. For each sample, first a predictor calculates a prediction of the coded sample based on previously coded samples. Then the prediction error, which is the difference between a sample and its prediction, is transmitted to the receiver. There, the same prediction, calculated in the decoder, is added back to the received prediction error. Consequently, the decoder is a recursive loop containing an adder and a predictor based on previously decoded samples. In order to reduce the bit-rate, the prediction errors can be quantized and/or clipped. This causes differences between the decoder output and the original. These differences are called coding errors. When there are coding errors in the MSB's of a sample due to quantization or clipping of prediction errors, transmission of the LSB's of the said sample is useless and the available channel bit-rate is not optimally used.

Predictive coding or Differential Pulse Code Modulation (DPCM) is often combined with Variable Length Coding (VLC) or Huffman coding of the prediction errors. VLC coding significantly improves the compression, but considerably increases the complexity. In order to guarantee compression in the case of DPCM without VLC, the transmitted prediction errors should be quantized and/or clipped to a range called "clip range". However, in applications of lossless or nearly lossless coding, quantization should be avoided and the prediction errors should be as much as possible within the clip range.

In WO 83/03727, W. Kehler discloses a "Modulation and coding method with range prediction and reduced bit rate adapted to a signal", which is an improved DPCM scheme that predicts a range called prediction range instead of a single prediction value. Instead of the prediction error, the position of the coded sample within the prediction range is transmitted. The prediction range can be used as clip range.

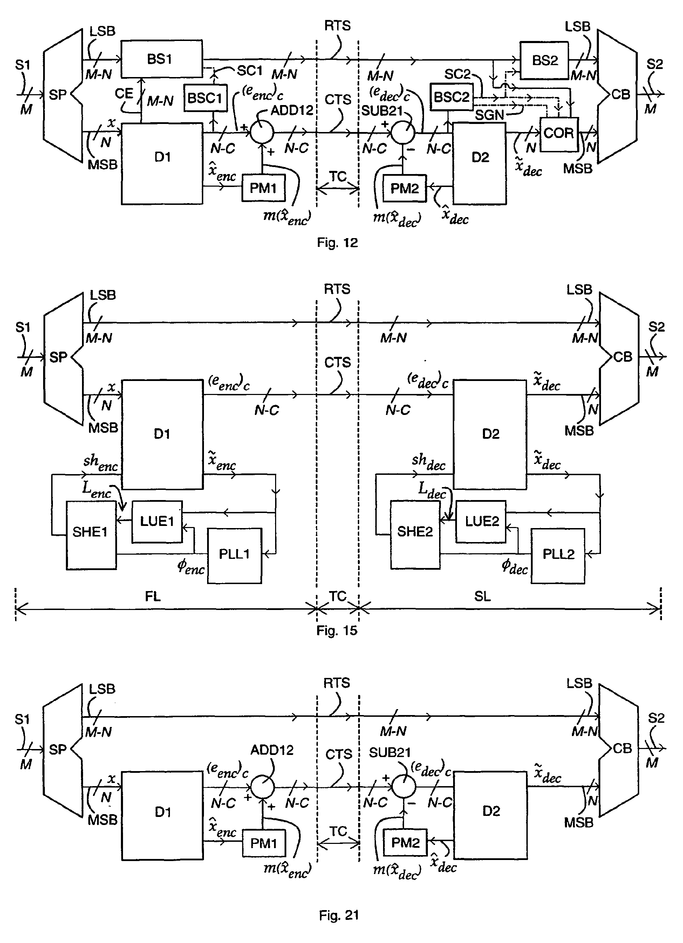

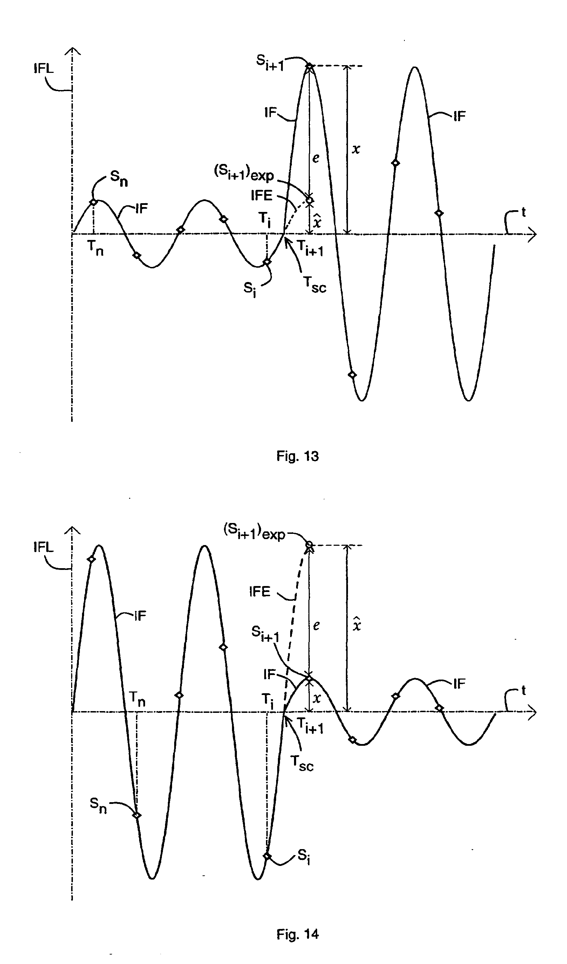

The published US patent US 4 791 483 describes an adaptive DPCM video encoder generating a bit reduced serial digital output signal. A predicted value of the video signal is generated, which is subtracted from the composite video signal and on this way a difference signal is produced. The difference signal is quantized to produce a quantized difference signal from which the predicted value is derived. The used quantization transfer function is non-linear and a plurality of quantization transfer functions are selectable according to the size of the step transitions as determined from the quantized difference signal. Figures 12 and 13 of the US patent give each a different example of such a quantization transfer function, whereby in Fig. 12 a fine quantization transfer function is represented and in Fig. 13 a coarse one.

Predictive coding or DPCM is based on a recursive loop in the decoder, and is therefore sensitive to transmission errors. The robustness against transmission errors can be improved by Hybrid DPCM (HDPCM) as published by Van Buul in "Hybrid DPCM, a Combination of PCM and DPCM", IEEE Trans. Commun., Vol. COM-26, No. 3, pp. 362-368, March 1978. HDPCM has been applied by Van Buul to video only. After a transmission error, or when the decoder does not start decoding the transmitted bit-stream from the beginning (i.e., after a random access), the predictions in the DPCM decoder are not the same as in the DPCM encoder. HDPCM forces the decoder predictions to converge to the encoder predictions, as will be described in the enabling description of the first embodiment below. However, with HDPCM, when a decoder prediction converges almost completely to the encoder prediction after a transmission error or after a random access, a big prediction error can be decoded by the HDPCM decoder as a prediction error of nearly the same absolute value but with the opposite sign (described more in detail below), causing severe divergence between decoder and encoder predictions. This is especially the case with digitised television IF signals, where big prediction errors occur more often than in the case of video signals.

## Summary of the invention

It is an aim of the present invention to provide a method for processing a digital signal, so that it can be compressed and transported over an existing transport channel featuring a known maximum bandwidth and/or a known maximum bit rate which is lower than the bandwidth respectively bit-rate of the said digital signal, thereby reducing the bit rate of the digital signal to be transmitted, and thereby keeping the distortions of the reproduced digital signal after compression, transport and decompression to a minimum. When the said digital signal is a digitised television IF signal, the visible and audible distortions should remain minimum. It is an aim to keep the implementation complexity of the method of this invention low and to keep the disclosed compression lossless or nearly lossless.

This is achieved by a method for the transmission of a first digital signal from a first location over a transport channel to one or more second locations where it is received as a second digital signal which is substantially equal to the first digital signal. A sample of the first digital signal, represented by M bits, being the total of N most significant bits and M-N least significant bits, N being smaller than or equal to M, is transported over the transport channel as a transport sample of a transport channel bit stream. The N most significant bits are compressed to N-C bits, C being smaller than N and larger than 0. The said N-C bits after compression are transported as a "compressed transport sample". Next to the (N-C)-bit compressed transport sample, there is a (M-N)-bit "residual transport sample" which is transported over the transport channel.

The N-C bits of the compressed transport sample are obtained through predictive coding of the N most significant bits of the corresponding sample of the first digital signal, whereby to each sample of the first digital signal corresponds at least a "prediction", a "prediction error" and a "clipping error". The prediction represents the predicted N most significant bits of the sample of the first digital signal whereby the prediction is based on previously compressed samples. The prediction error represents the difference between the N most significant bits of the sample of the first digital signal and the said prediction. The clipping error represents the difference between the prediction error and a "clipped prediction error", which is the prediction error clipped by a first clipper to a "clip range" [A..B], A and B being integers and B-A being equal to or smaller than $2^{(N-C)}$-1. So, the clipped prediction error can be represented by means of N-C bits.

The residual transport sample, represented by M-N bits, is equal to the M-N least significant bits of the said sample of the first digital signal in the case that the said prediction error corresponding to the said sample of the first digital signal is in the range [A..B]. In the other case, it is equal to a substitution value which is a function of the clipping error corresponding to the said sample of the first digital signal, whereby the output value of the said function of the clipping error can be represented by M-N bits. It is preferred that, in the case that the prediction error corresponding to the said sample of the first digital signal is not in the range [A..B], the said substitution value (CE) is obtained by first taking the absolute value of the clipping error of the said sample (S1) of the first digital signal (DS1), and then clipping the said absolute value to a range which can be represented by M-N bits.

The compressed transport sample can be the said clipped prediction error, but is by preference an in the range [A..B] wrapped around sum of the clipped prediction error and a mapped value of the prediction. The mapped value of the prediction is the prediction mapped on a range [D..E], E and D being integers and E-D being equal to or smaller than $2^{(N-C)}$-1. The prediction is by preference mapped or quantized in a non-uniform way, such that the quantisation is fine for prediction values corresponding to small input amplitudes and rough for prediction values corresponding to big amplitudes of the first digital signal.

Of the said clip range [A..B], B-A is by preference smaller than $2^{(N-C)}$-1 if the compressed transport sample is the in the range [A..B] wrapped around sum of clipped prediction error and mapped prediction.

The residual transport signal is by preference transported in PCM.

The clip range [A..B] can be fixed (being not shiftable) for all samples, but is by preference shiftable in every sample over a shift *sh*, the shift *sh* in a sample being a function of one or more actual parameters of the said sample of the first digital signal, the clip range then being [A+*sh*..B+*sh*]. When the to be transported digital signal is a digitised television IF signal, the said actual parameters are the estimated phase of the IF carrier and the estimated luminance of the video signal comprised in the television IF signal.

The aims of the invention are also achieved by other methods which combine only some of the method steps of the "preferred" method of the present invention described before, albeit with a lower grade compression and/or transport and/or decompression of a digital signal.

A first method thus combining only some of the method steps of the preferred method of the present invention is a method for the transmission of a first digital signal from a first location over a transport channel to one or more second locations where it is received as a second digital signal which is substantially equal to the first digital signal. A sample of the first digital signal represented by N bits is transported over the transport channel as a transport sample represented by N-C bits, C being smaller than N and larger than 0. These N-C bits are obtained through predictive coding of the N bits of the sample of the first digital signal, whereby with each sample of the first digital signal corresponds at least a prediction representing the predicted N bits of the sample of the first digital signal and a prediction error representing the difference between the N bits of the sample of the first digital signal and the said prediction. The prediction is based on previously compressed samples. The transport sample is an in the range [A..B] wrapped around sum of the prediction error clipped to a range named clip range [A..B], A and B being integers and B-A being equal to $2^{(N-C)}$-1, and a mapped value of the prediction which has been mapped on a range [D..E], E and D being integers and E-D being equal to or smaller than $2^{(N-C)}$-1.

A second method thus combining only some of the method steps of the preferred method of the present invention is a method for the transmission of a first digital signal from a first location over a transport channel to one or more second locations where it is received as a second digital signal which is substantially equal to the first digital signal. A sample of the first digital signal represented by N bits is transported over the transport channel as a transport sample represented by N-C bits, C being smaller than N and larger than 0. These N-C bits are obtained through predictive coding of the N bits of the sample of the first digital signal, whereby with each sample of the first digital signal corresponds at least a prediction representing the predicted N bits of the sample of the first digital signal and a prediction error representing the difference between the N bits of the sample of the first digital signal and the said prediction. The prediction is based on previously compressed samples. The transport sample is the prediction error clipped to a range named clip range, which can be represented by means of N-C bits, whereby the clip range is shiftable in function of one or more actual parameters of the first digital signal.

It is furthermore an aim of the present invention to provide an apparatus for the compression and/or transport and/or decompression of a digital signal, and of a digitised television IF signal in particular.

Transmitting apparatuses are provided wherein a digitised television IF signal is transformed into a transport channel bit-stream for transmission of the said digitised television IF signal from a first location to one or more second locations. Receiving apparatuses which correspond to the provided transmitting apparatuses are also provided. These said receiving apparatuses transform a transport channel bit-stream, containing a first digitised television IF signal which has been compressed according to the present invention, into a second digitised television IF signal by a method corresponding to the method of compression of the said first digitised television IF signal.

A transmitting apparatus is provided, comprising a splitter, an encoder DPCM-core, an output for the transport channel bit-stream, a first location clipping detector, and a first location substitutor. Transmitting apparatuses are provided wherein there is in addition a combination of a prediction mapper and a wrap-around adder and/or a combination of a phase locked-loop, a luminance estimator, and a shift estimator.

A short description of the here above listed parts of the provided transmitting apparatuses is given here below. For a more extended description of these listed parts is in particular referred to the description of the first embodiment of the present invention.

In the splitter, a sample of the said digitised television IF signal is split into N most significant bits and M-N least significant bits. In the encoder DPCM-core, the N most significant bits of a sample of the said digitised television IF signal are compressed into a N-C-bit word clipped prediction error. In the first location clipping detector, a first location PCM-bits substitution control signal is generated, indicating what is to be transmitted as residual transport sample, either the M-N least significant bits of the sample of the first digitised television IF signal, or a substitution value being a function of the clipping error corresponding to the said sample of the first digitised television IF signal. In the first location substitutor, the M-N least significant bits are substituted by a substitution value according to the first location PCM-bits substitution control signal.

In the prediction mapper, a mapped prediction is generated from an encoder prediction from the encoder DPCM-core. In the wrap-around adder, a mapped prediction is added to a corresponding clipped prediction error, the sum then being wrapped around to obtain a compressed transport sample.

In the phase-locked loop, the phase of the IF carrier of the digitised television IF signal is estimated, based on a locally decoded television IF signal from the encoder DPCM-core. In the luminance estimator, the luminance of the video signal contained in the digitised television IF signal is estimated, based on a decoded television IF signal and on the estimated phase of the IF carrier, resulting in an estimated luminance. In the shift estimator, a shift is estimated, based on the estimated phase of the IF carrier and on the estimated luminance.

The combination of a phase-locked loop, a luminance estimator, and a shift estimator provides a shiftable clip range for the prediction errors. In this case, the encoder DPCM-core contains a clipper which clips the prediction error to a range which is shifted.

A receiving apparatus is provided, comprising an input for a transport channel bit stream, a decoder DPCM-core, a combiner, a second location clipping detector, a second location substitutor, and a MSB corrector. Receiving apparatuses are provided wherein there is in addition a combination of a prediction mapper and a wrap-around subtractor and/or a combination of a phase-locked loop, a luminance estimator, and a shift estimator.

A short description of the here above listed parts of the provided receiving apparatuses is given here below. For a more extended description of these listed parts is in particular referred to the description of the first embodiment of the present invention.

In the decoder DPCM-core, the N-C bits of a sample of the compressed transport stream are decompressed to N most significant bits of an output sample. In the combiner, the M-N least significant bits and N most significant bits of a sample are combined to an output sample. In the second location clipping detector, a second location PCM-bits substitution control signal is generated, indicating what is to be selected as M-N least significant bits of the output sample, as well as a sign signal, being the sign bit of the clipping error. The second location substitutor switches between the received M-N least significant bits from the residual bit stream and a fixed replacement according to the second location PCM-bits substitution control signal. The MSB corrector adds to or subtracts from the output of the decoder DPCM-core, the output value of mapping by means of a second function of the received residual transport sample, according to the second location PCM-bits substitution control signal and the sign signal.

Other transmitting and receiving apparatuses are provided which are built up with only some of the parts used in the above described provided apparatuses and with equivalent mutual interconnections, however offering a lower grade compression and/or transport and/or decompression of a digital signal, a digitised television signal in particular.

A transmitting apparatus is provided, comprising at least an encoder DPCM core, an output for the transport channel bit-stream, a prediction mapper, and a wrap-around adder, the corresponding receiving apparatus also being provided and comprising at least an input for the transport channel bit-stream, a decoder DPCM-core, a prediction mapper and a wrap-around subtractor.

A transmitting apparatus is provided, comprising at least an encoder DPCM core, an output for the transport channel bit-stream, a phase-locked loop, a luminance estimator and a shift estimator, the corresponding receiving apparatus also being provided and comprising at least an input for the transport channel bit-stream, a decoder DPCM-core, a phase-locked loop, a luminance estimator and a shift estimator.

A transmitting apparatus is provided, comprising at least an encoder DPCM core, an output for the transport channel bit-stream, a prediction mapper, a wrap-around adder, a phase-locked loop, a luminance estimator and a shift estimator, the corresponding receiving apparatus also being provided and comprising at least an input for the transport channel bit-stream, a decoder DPCM-core, a prediction mapper, a wrap-around subtractor, a phase-locked loop, a luminance estimator and a shift estimator.

## Short description of the drawings

The invention will now be described by means of the embodiments represented in the drawings.

In the drawings :

Fig. 1 shows a block diagram illustrating the transport of a digital signal from a first location over a transport channel to a second location;

Fig. 2 shows a typical spectrum H(f) of a digitised television IF signal;

Fig. 3 shows a sampled television IF signal with negative modulation during an interval located around a vertical synchronisation pulse;

Fig. 4 shows a detail of Fig. 3 for the samples numbered from 16500 to 16650, illustrating sampled television IF signal with negative modulation at a transition from a high to a low modulating luminance;

Fig. 5 shows a block diagram illustrating the compression, transport and decompression of a digital signal according to a first embodiment of the present invention;

Fig. 6 shows a block diagram illustrating an elementary but not complete implementation of the first, second and third embodiments of the present invention, whereby DPCM is implemented for transport of the N most significant bits;

Fig. 7 shows a block diagram illustrating a prior art method for compression, transport and decompression of a digital signal using DPCM;

Fig. 8 shows a block diagram illustrating a DPCM encoder core and decoder core of the present invention as implemented in the embodiments;

Fig. 9 shows a number of scales illustrating ranges of signals which are present in the embodiments of the present invention;

Fig. 10 shows a block diagram illustrating HDPCM (Hybrid Differential Pulse Code Modulation) as implemented in the first and second embodiments;

Fig. 11 shows a block diagram illustrating a partial implementation of the first embodiment of this invention, whereby DPCM is implemented for transport of the N most significant bits and PCM-bit substitution is carried out on the M-N least significant bits;

Fig. 12 shows a block diagram, illustrating a partial implementation of the first embodiment of this invention, whereby HDPCM is implemented for transport of the N most significant bits and PCM-bit substitution is carried out on the M-N least significant bits;

Fig. 13 shows, for a television IF signal with negative modulation, a transition from a high to a low luminance whereby the first sample after the transition coincides with a positive peak of the IF carrier;

Fig. 14 shows for a television IF signal with negative modulation, a transition from a low to a high luminance whereby the first sample after the transition coincides with a positive peak of the IF carrier;

Fig. 15 shows a block diagram, illustrating the addition of a dynamic clip range shifting to the elementary implementation of the first, second and third embodiments of the present invention, the block diagram corresponding to the third embodiment of the present invention;

Fig. 16 shows a block diagram of an IF carrier estimation, being a phase-locked loop (PLL);

Fig. 17 shows a block diagram of a luminance estimator (LUE);

Fig. 18 shows a block diagram of a shift estimator (SHE);

Fig. 19 shows a block diagram illustrating an implementation of a dynamic clip range shifting;

Fig. 20 shows several time diagrams to illustrate the time delay between a sample and a corresponding calculated shift amount;

Fig. 21 shows a block diagram, corresponding to the second embodiment of the present invention; and

Fig. 22 shows a block diagram of a prediction error clipper (PEC1).

In the drawings, same elements are represented by the same references.

## Enabling description of preferred embodiments

### First preferred embodiment

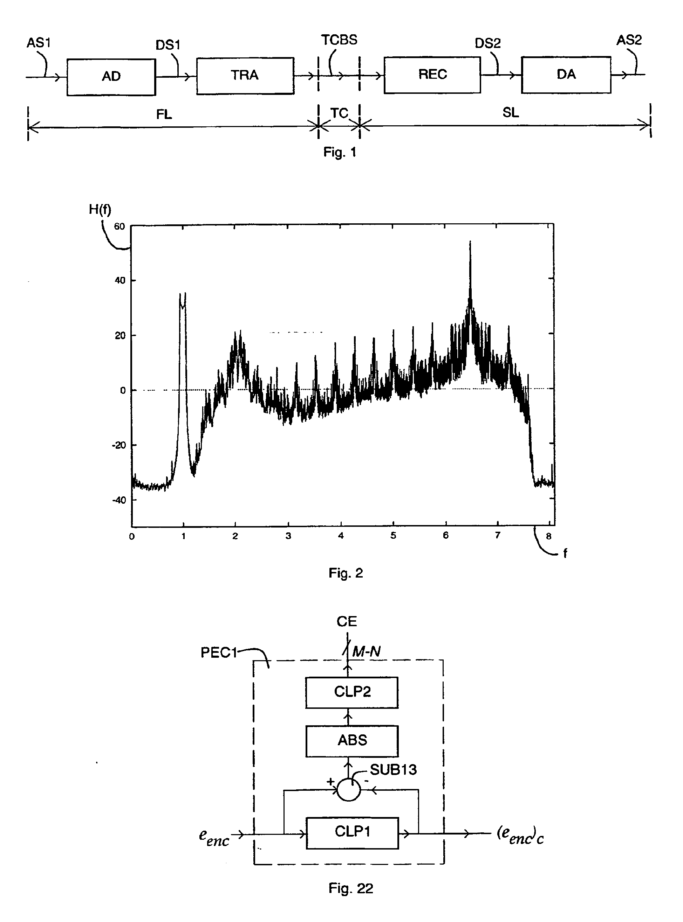

Fig. 1 shows a first embodiment of the present invention which is a method for the transport of a first digitised television IF signal DS1 over a transport channel TC from a first location FL to a second location SL, where it is received as a second digitised television IF signal DS2. The bit-rate of the digitised television IF signal DS1 is fitted in the available channel bit rate, according to the present invention. The first digitised television IF signal DS1 is a modulated television signal at an IF carrier frequency according to one of the existing transmission standards as mentioned in ITU-R Recommendation 470-2, "Television Systems", 1986.

At the first location FL, the first digitised television IF signal DS1 is transformed in a transmitter TRA into a transport channel bit-stream TCBS. The transport channel bit-stream TCBS is transmitted over the transport channel TC from the first location FL to the second location SL. At the second location SL, the received transport channel bit-stream TCBS is transformed in a receiver REC into a second digitised television IF signal DS2.

The first digitised television IF signal DS1 may optionally be the output of an analog-to-digital converter AD with a first analog television IF signal AS1 at its input. The second digitised television IF signal DS2 may optionally be the input of a digital-to-analog converter DA with a second analog television IF signal AS2 at its output.

As it is an aim of the invention to keep the visible and audible distortions to a minimum when reproducing the transported digitised television IF signal, the second digitised IF signal DS2 should be substantially equal to the first digitised television IF signal DS1.

For the first embodiment, a television IF signal according to the PAL B/G standard is considered. The IF frequency is 38.9 MHz. The first digitised television IF signal DS1 is sampled at a sampling rate of 16.2 MHz with 11 bits per sample. The clock that indicates the sampling time points is called the "sampling clock". The bit rate of the first digitised television IF signal DS1 is 16.2*11 or 178.2 Mbits/s. Over the transport channel TC (e.g. SONET OC-3 SDH STM-1), signal transport with a payload bit-rate up to 149.76 Mbits/s is available.

Fig. 2 shows a typical spectrum of a digitised television IF signal, whereby a PAL B/G baseband television signal is modulated to an IF carrier with a frequency of 38.9 MHz, sampled at 16.2 MHz. The horizontal axis $f$ is a frequency scale between 0 MHz and 8.1 MHz, and the vertical axis $H(f)$ is an amplitude scale between -50 dB and +60 dB.

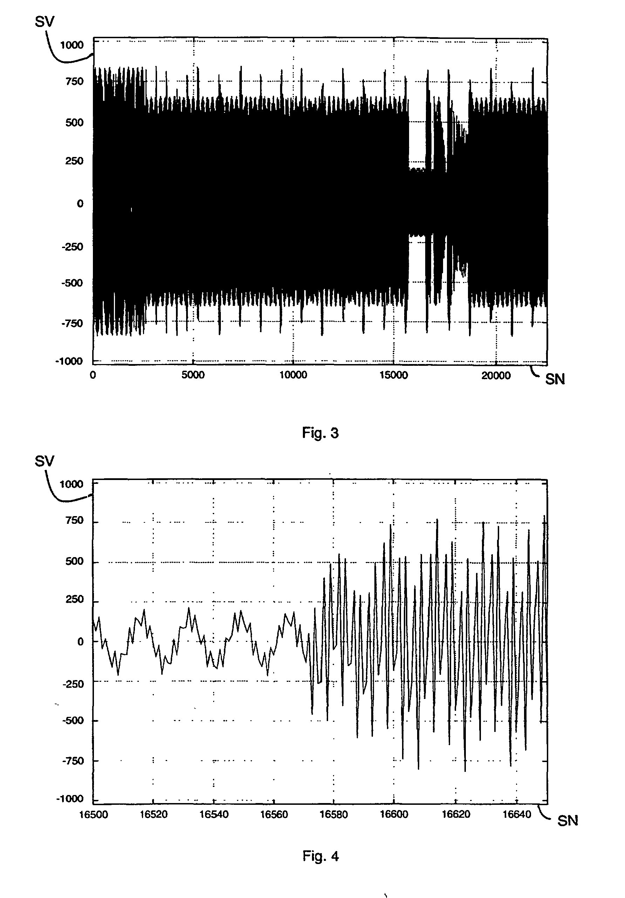

Fig. 3 shows a sampled television IF signal during an interval located around a vertical synchronisation pulse, the sampling frequency being 16.2 MHz. The horizontal axis SN (sample number) is a time scale with numbers of consecutive samples from 0 to 22500 as units, and the vertical axis SV (sample value) is an amplitude scale representing the amplitude of the samples of the sampled television IF signal after sampling with 11 bits per sample. Due to the negative modulation, an amplitude peak which corresponds to a horizontal sync pulse is visible approximately every 1000 samples. Fig. 4 shows a detail of Fig. 3 for the samples numbered from 16500 to 16650, illustrating the sampled television IF signal at a transition from a high to a low modulating luminance.

The here above mentioned parameters of the first digitised television IF signal DS1 to be transported (PAL B/G as transmission standard, 38.9 MHz as IF carrier frequency, 16.2 MHz as sampling rate, 11 bits per sample), and the here above mentioned specifications of the transport channel are choices made to describe this first embodiment of the present invention. They can easily be replaced by other typical parameters and specifications known to a person skilled in the art.

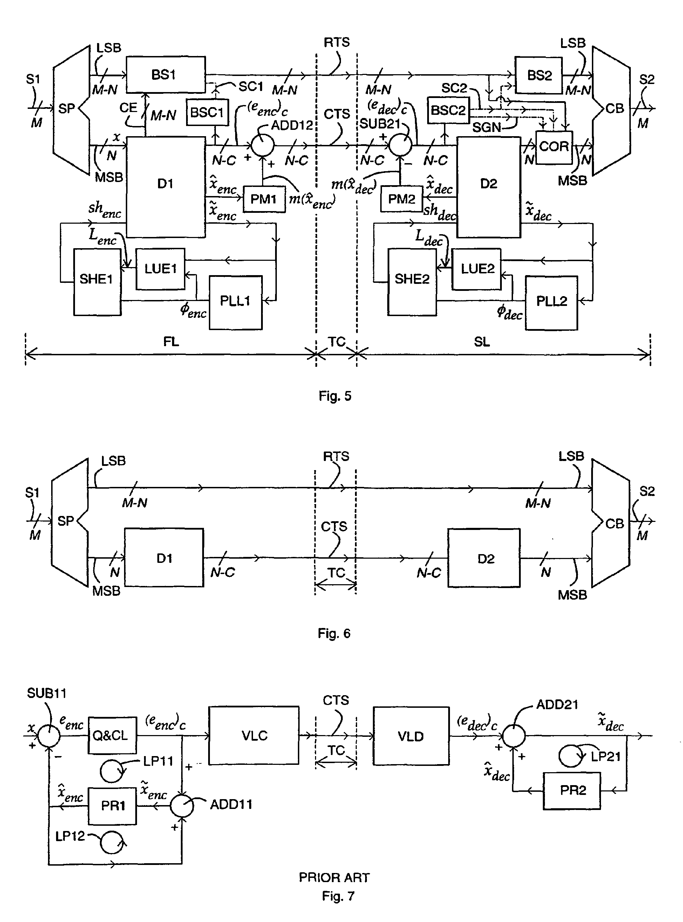

Fig. 5 shows a block diagram of a full implementation of the first embodiment of the present invention. The description of this embodiment is broken down into smaller sections and is built up step-by-step, whereby the sections of the description correspond to parts wherein this embodiment and the method of the invention can be subdivided, and whereby is referred to additional figures. As will be seen from the description below, the consecutively described parts of this embodiment and their interconnections from an elementary implementation to a full implementation, correspond to a gradually improving method for obtaining the aims of the invention. The parts of this embodiment are therefore named "elementary implementation" and "improving parts". Some of these said improving parts can operate independent from other improving parts. Consequently, a previously described improving part is not necessarily needed for the operation of an improving part described further. Some of the said improving parts contain one or more improvements themselves (or extra-improving parts) which are also introduced step-by step, and/or one or more divisional parts which draw up the said improving part.

For the sake of clarity, an overview is given here of how the description of this first embodiment of the invention is built-up. After a description of the "elementary implementation", "HDPCM" is described as a first improving part. The description of HDPCM comprises a description of HDPCM itself followed by descriptions of two HDPCM extra-improving parts for HDPCM, namely "reduction of the clip range" and "non-uniform mapping". Then follows the description of a second improving part named "PCM-bit substitution" which is not subdivided. Then follows a description of a third improving part named "Dynamic clip range shifting" comprising three divisions which are, after an introduction, described consecutively and which are named "IF carrier estimation", "luminance estimation" and "shift calculation". The description of the shift calculation comprises the description of a further improvement called "dejitter".

Fig. 5 shows the path of a sample S1 of the first digitised television IF signal from the first location FL, where it has been transformed in a sample of the transport channel bit stream, over the transport channel TC to the second location SL, where it is transformed into a sample S2 of the second digitised television IF signal. When the description of this embodiment mentions from here on a sample, it means the sample S1 or a transformed version of that same sample S1.

The parts on the left side of Fig. 5 belong to the first location FL and correspond to the transmitter TRA in Fig. 1. The parts on the right side of Fig. 5 belong to the second location SL and correspond to the receiver REC in Fig. 1.

Fig. 6 shows the elementary implementation of this embodiment, hereby making omission of all improving parts described later.

A sample S1 of the first digitised television IF signal, having a bit-resolution of M bits (11 in this embodiment), is first split at the first location FL with a splitter SP into N MSB's (Most Significant Bits) and M-N LSB's (Least Significant Bits). The value N is by preference 8, and M-N is consequently 3. On Fig. 5, Fig. 6 and other figures, the bit resolution of signals passing through some of the interconnections is marked by means of a slash and the bit-resolution (e.g. "/M", "/N" or "/N-C").

The M-N LSB's, having usually a noisy character, are difficult to compress and are therefore, as far as they are not replaced by other bits (see below), by preference transmitted uncompressed in PCM (Pulse Code Modulated). Therefore they are further also called "PCM-bits".

The N MSB's are compressed to N-C bits in a further described encoder DPCM-core D1 using DPCM (Differential Pulse Code Modulation) and transmitted as an N-C-bit word. Therefore, the said N MSB's are sometimes called "DPCM-bits", whereas the bits of the N-C-bit word are sometimes called the "compressed DPCM-bits". In this embodiment, C is chosen to be 2, N-C consequently being 6. However, any other choice may be made for C.

The transport channel bit-stream TCBS of Fig. 1 thus consists of a compressed bit-stream (of compressed DPCM-bits) and a residual bit-stream (of PCM-bits). In Fig. 5 and 6, the compressed bit-stream is represented by a compressed transport sample CTS, and the residual bit-stream is represented by a residual transport sample RTS, both being transformed versions of a part of the sample S1.

At the second location SL, the N-C bits of a received N-C-bit word are decompressed to N MSB's in a decoder DPCM-core D2 described below. The N decompressed MSB's are combined in a combiner CB with the received corresponding M-N LSB's of the same sample, as far as these LSB's have not been replaced by other bits (see below), to form an M-bits sample S2 of the second television IF signal.

The split of the M-bit samples S1 of the first digitised television IF signal into two parts has the advantage that the width of the DPCM-loop can be smaller than M bits (smaller than 11 bits for this embodiment), which reduces the complexity of the hardware for the compression and which permits a sufficiently fast operation of the DPCM-loop.

The DPCM part of this embodiment, consisting of two DPCM-cores, being an encoder DPCM-core D1 in an encoder at the first location FL and a decoder DPCM-core D2 in a decoder at the second location SL, is now further explained. By the encoder is meant the part of the transmitter where the DPCM-bits of a sample S1 are transformed or encoded to a compressed transport sample CTS, the encoder DPCM-core D1 being a part or the whole of it. By the decoder is meant the part of the receiver where a received compressed transport sample CTS is transformed or decoded to DPCM-bits of a sample S2, the decoder DPCM-core D2 thus being a part or the whole of it.

Fig. 7 shows a prior art DPCM configuration for transmitting and receiving a digital signal. A sample $x$ of the digital signal to be transported over a transport channel TC is encoded before being transmitted as a compressed transport sample CTS making use of a predictor PR1, a quantizer and clipper Q&CL, an adder ADD11, a subtractor SUB11 and a variable length coder VLC, together forming an encoder. The received transport sample CTS is decoded to become a reconstructed sample $\tilde{x}_{dec}$ of the digital signal to be transported, making use of a variable length decoder VLD, a predictor PR2 and an adder ADD21, together forming a decoder.

In both encoder and decoder, the same prediction is made from previously transmitted and decoded samples of the digital signal to be transported.

The encoder contains two recursive loops LP11 and LP12, whereas the decoder contains only one recursive loop LP21. The loop LP21 corresponds to loop LP12, and therefore, LP12 is called the "local decoder in the encoder".

In the encoder of the prior art DPCM configuration, a prediction $\hat{x}_{enc}$ of a sample $x$, made by the predictor PR1 from the previously locally decoded *samples* $\tilde{x}_{enc}$, is subtracted in SUB11 from the sample $x$, resulting in a prediction error $e_{enc}$. The prediction error $e_{enc}$ is quantised and/or clipped in the quantizer and clipper Q&CL to become a clipped prediction error $(e_{enc})_c$. This quantising and/or clipping is carried out in order to limit the number of possible code words to be transmitted. The clipped prediction error $(e_{enc})_c$ is added in ADD11 to the prediction $\hat{x}_{enc}$, resulting in a reconstructed input sample $\tilde{x}_{enc}$ (being a locally decoded sample in the encoder), which is the input of the predictor PR1 for making a prediction of future samples.

The quantised and clipped prediction error $(e_{enc})_c$ is input to the optional variable length coder VLC of which the output is the compressed transport sample CTS. As prediction errors usually have a histogram which is centred around zero, variable length-coding can significantly reduce the bit-rate of the prediction errors.

In the decoder of the prior art DPCM configuration, the received compressed transport sample CTS is applied to an optional variable length decoder VLD of which the output is a clipped prediction error $(e_{dec})_c$ of the decoder. The clipped prediction error $(e_{dec})_c$ is applied to a recursive decoder loop LP21 formed by the adder ADD21 and the predictor PR2. The prediction error $(e_{dec})_c$ is added in ADD21 to a prediction $\hat{x}_{dec}$ made by the predictor PR2 from the previously decoded sample, resulting in the reconstructed sample $\tilde{x}_{dec}$.

If there are no transmission errors and when the encoder and decoder start synchronously, the outputs of both loops LP12 and LP21, respectively $\tilde{x}_{enc}$ and $\tilde{x}_{dec}$, are equal.

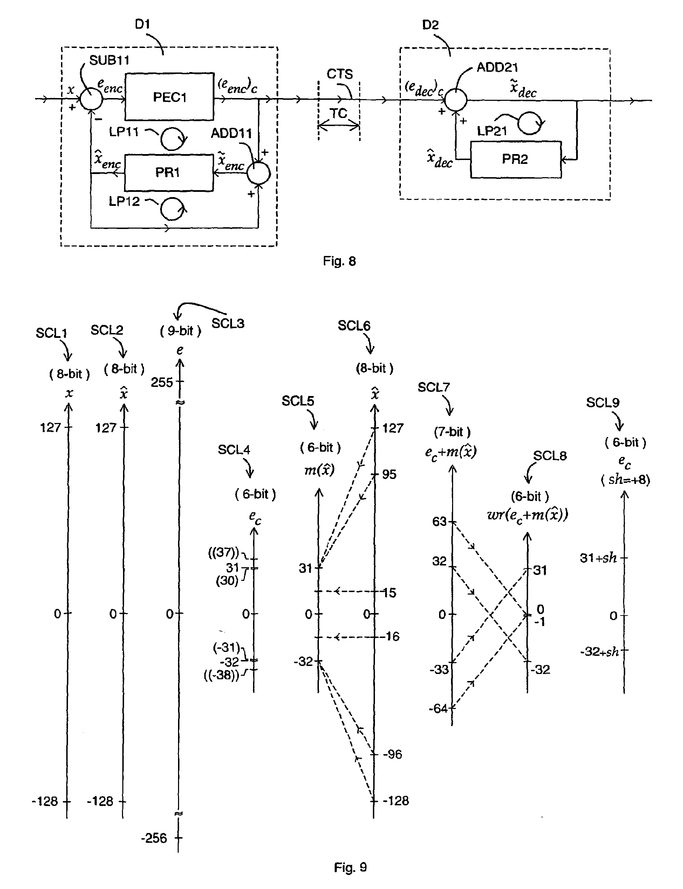

Fig. 8 shows the DPCM part of the first embodiment of the present invention, being an adapted version of the prior art DPCM configuration shown in Fig. 7. In order to limit the complexity of the implementation, by preference no variable length coding is implemented. With variable length coding, a difficult word synchronisation has to be implemented using synchronisation words, a bit-rate and buffer control, stuffing and an exception handling for cases of buffer overflow. If no variable length coding is implemented, the clipped and quantised prediction errors are coded with words of fixed length.

A prediction error $e_{enc}$ is only clipped; therefore the quantizer and clipper Q&CL is replaced by a prediction error clipper PEC1. Quantization is in this preferred embodiment not implemented because it is an aim of the invention to have a lossless or near lossless compression.

Due to the fixed length coding, the number of available code words in the code book is limited. Therefore, in the encoder the prediction errors $e_{enc}$ are clipped to a range [A..B], further also called the clip range. A and B are integers with $B-A+1 \leq 2^{(N-C)}$, which allows a (N-C)-bit code word for every possible value of the clipped prediction error.

For this embodiment, N-C is 6 bits. The preferred range of prediction errors for this embodiment is [-32..+31]. However, for reasons explained below, the said range of prediction errors will be reduced by preference to [-31..+30]. In some cases, the clip range will be shifted over an amount "$sh$" to the range [A+$sh$..B+$sh$], with $sh$ varying from sample to sample as will be described below.

A preferred kernel for compression of a digitised television IF-signals of this embodiment is a DPCM-loop using an 8-tap linear prediction (LPC). The coefficients of the linear prediction are optimised for the statistical characteristics of a representative number of television IF signals.

Fig. 9 shows a number of scales illustrating the ranges of signals which are present in this embodiment of the present invention for which N equals 8 and C equals 2. Scale SCL1 is for the N MSB's $x$, scales SCL2 and SCL6 for the predictions $\hat{x}$, scale SCL3 for the not clipped prediction errors $e$, and scale SCL4 for the clipped prediction errors $e_c$ ; on top of each scale, the bit-resolution is mentioned. The scales SCL5, SCL7, SCL8 and SCL9 are described below.

**First improving part, named "HDPCM"**

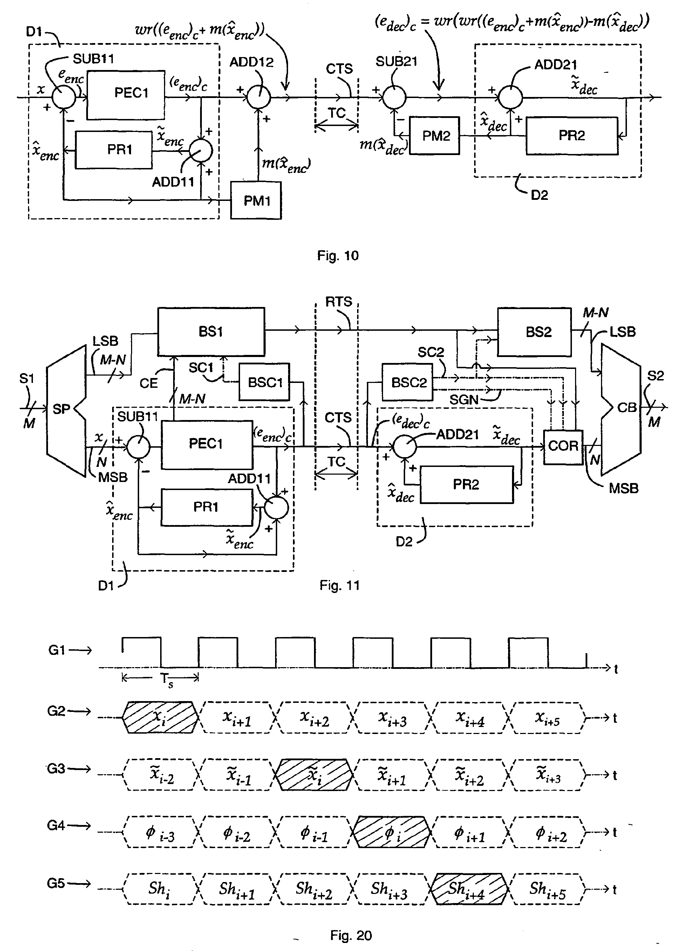

In order to improve the transport of samples, or more specifically, to improve the robustness against transmission errors, and to allow a random access of the decoder to the transported bit-stream of compressed data, i.e., the decoder can start decoding at any time after start-up of the encoder without waiting for start codes, the above described encoder and decoder are by preference extended to Hybrid Differential Pulse Code Modulation or HDPCM. This HDPCM is a said improving part. HDPCM is described in IEEE Transactions on Communication Technology, Vol. COM-26, No. 3, pp. 362-368, March 1978, Van Buul, "Hybrid DPCM, a combination of PCM and DPCM". Fig. 10 shows the extension of the above described encoder and decoder DPCM-cores D1 and D2 with prediction mappers PM1 and PM2 respectively, in order to obtain HDPCM. With HDPCM, both the encoder and the decoder map their predictions on a value using the same prediction mapping. In a mapping, each possible input value has one corresponding output value. This mapping can be considered as a quantisation of the prediction. This said mapping preserves the ordering of the prediction values. This means that when the encoder prediction $\hat{x}_{enc}$ is higher than the decoder prediction $\hat{x}_{dec}$, because of a previous transmission error or because of a random access of the decoder, the mapped value of the encoder prediction $m(\hat{x}_{enc})$ is also higher than or equal to the mapped value of the decoder prediction $m(\hat{x}_{dec})$ :

if

$$\hat{x}_{enc} > \hat{x}_{dec} \ ,$$

then

$$m(\hat{x}_{enc}) \geq m(\hat{x}_{dec}) .$$

The range of the mapping output is [D..E] with D and E being integers and E-D being equal to $2^{(N-C)}-1$. For this embodiment with N-C=6, [D..E] is by preference [-32..+31].

For a given sample in a HDPCM coding system, it is not the prediction error which is transmitted, but the sum of the clipped prediction error $(e_{enc})_c$ and the mapped encoder prediction $m(\hat{x}_{enc})$. In the block diagram of HDPCM in Fig. 10, the adder ADD12 in the encoder makes the sum of $(e_{enc})_c$ and $m(\hat{x}_{enc})$. At the receiver, the mapped prediction of the decoder $m(\hat{x}_{dec})$ is then subtracted from the received sum of prediction error and mapped encoder prediction, resulting in a decoder output $(e_{dec})_c$ of the received sample (subtractor SUB21 in the decoder in Fig. 10).

For the above said addition and subtraction of prediction error and mapped prediction, the results are wrapped-around. In the present embodiment with N-C or 6 DPCM bits, this wrap-around is a kind of modulo-operation which is mathematically described by the following equations, where "mod" means the modulo operation and where $y$ is an integer number :

$$wr(y) = ((y+2^{(6-1)}) \bmod 2^6) - 2^{(6-1)}$$

or

$$wr(y) = ((y+32) \bmod 64) - 32$$

Consequently, $wr(+32) = -32$, $wr(+33) = -31$, and so on, and $wr(-33) = +31$, $wr(-34) = +30$, and so on.

In Fig. 9, scale SCL5 illustrates the range of the mapped predictions $m(\hat{x})$, scale SCL7 the range of the sums of a clipped prediction error $e_c$ and a mapped prediction $m(\hat{x})$, and scale SCL8 the range of the wrapped around sums of a clipped prediction error $e_c$ and a mapped prediction $m(\hat{x})$; on top of each scale, the bit-resolution is mentioned. The wrap-around is illustrated by means of dashed lines between the scales SCL7 and SCL8.

Because of the wrap-around, the number of possible code words remains the same for HDPCM as for DPCM. For this described embodiment with N-C or 6 DPCM-bits, the number of code words for DPCM or HDPCM is $2^{(N-C)}$ or $2^6$ or 64.

The clipped prediction error $(e_{dec})_c$ which is the input to the DPCM decoder (see Fig. 10) is given by :

$$(e_{dec})_c = wr( \ wr((e_{enc})_c + m(\hat{x}_{enc})) - m(\hat{x}_{dec}) \ )$$

Because of the nature of the wrap-around, this can be simplified to :

$$(e_{dec})_c = wr((e_{enc})_c + m(\hat{x}_{enc}) - m(\hat{x}_{dec}) \ )$$

When encoder and decoder have the same prediction for a given sample, i.e., $\hat{x}_{dec} = \hat{x}_{enc}$, the mapped decoder prediction $m(\hat{x}_{dec})$ is equal to the mapped encoder prediction $m(\hat{x}_{enc})$, and thus $(e_{dec})_c=(e_{enc})_c$.
When encoder and decoder don't have the same prediction, and if

$$-32 \leq (e_{enc})_c + m(\hat{x}_{enc}) - m(\hat{x}_{dec}) \leq +31$$

then :

$$(e_{dec})_c = (e_{enc})_c + m(\hat{x}_{enc}) - m(\hat{x}_{dec})$$

In this case, which happens almost all the time, it is as if the wrap-around in the decoder neutralises the wrap-around in the encoder.
So, if the prediction $\hat{x}_{dec}$ in the decoder is smaller than the prediction $\hat{x}_{enc}$ in the encoder because of a transmission error in a previous sample or a random access, the clipped prediction error $(e_{dec})_c$ in the decoder will be higher than or equal to the clipped prediction error $(e_{enc})_c$ in the encoder. If the clipped prediction error $(e_{dec})_c$ in the decoder is higher than the clipped prediction error $(e_{enc})_c$ in the encoder, the too low prediction $\hat{x}_{dec}$ of the decoder will be corrected. Indeed, $\hat{x}_{dec}+(e_{dec})_c$, which is the decoder output, will deviate less from $\hat{x}_{enc}+(e_{enc})_c$ than $\hat{x}_{dec}$ deviates from $\hat{x}_{enc}$.

**First extra-improving part to HDPCM, named "reduction of the clip range"**

When encoder and decoder don't have the same prediction, and if

$$(e_{enc})_c + m(\hat{x}_{enc}) - m(\hat{x}_{dec}) < -32$$

or

$$+31 < (e_{enc})_c + m(\hat{x}_{enc}) - m(\hat{x}_{dec})$$

then

$$(e_{dec})_c = (e_{enc})_c + m(\hat{x}_{enc}) - m(\hat{x}_{dec}) + n*64$$

with $n$ being an integer not equal to zero. In this case, the combination of wrap-around in the encoder adder ADD12 and decoder subtractor SUB21 will cause a severe deviation between $(e_{dec})_c$ and $(e_{enc})_c$. This case fortunately seldom happens.
If it happens, it is usually when the difference between the predictions $\hat{x}_{enc}$ and $\hat{x}_{dec}$ of resp. encoder and decoder are small and when at the same time the absolute prediction error is near to its maximum value. A small difference between the predictions of encoder and decoder occurs usually just before the complete resynchronisation of the decoder with respect to the encoder. A large prediction error occurs at sudden changes or non-stationarities of the video signal. In this embodiment with clipping to 6 bits, the extreme prediction errors are +31 and -32. If the clipped prediction error $(e_{enc})_c$ is for instance +31 and at the same instant, the mapped encoder prediction $m(\hat{x}_{enc})$ is +1 higher than the mapped decoder prediction $m(\hat{x}_{dec})$, the decoder will end up with a prediction error equal to +31+1 or +32 and this will be wrapped around to -32. So, the prediction error $(e_{dec})_c$ in the decoder has almost the same absolute value as the prediction error $(e_{enc})_c$ in the encoder, but the sign is the opposite. This looks as if there is a transmission error of 31-(-32) or +63. To sufficiently avoid such large errors in the output, the prediction error clip range is by preference reduced, in this embodiment from [-32..+31] to [-31..+30], while the adder in the HDPCM encoder and the subtractor in the HDPCM decoder keep their wrap-around for the range [-32..+31].

The reduction of the clip range as described above causes at sudden hardly predictable changes in the video information only errors that are almost imperceptible. However it has the advantage that the decoder corrects much better the deviation of the decoder from the encoder after transmission errors or after a random access.

**Second extra-improving part to HDPCM, named "non-uniform mapping"**

HDPCM more quickly corrects the deviation of the decoder from the encoder when the transported signal has a higher amplitude. With negative modulation, the correction happens more quickly for sync pulses than for bright image parts. If the transported image is for instance a completely white field, a transmission error typically lasts until the end of the horizontal line.

The error correcting efficiency of the applied HDPCM can be equalised between dark and bright image areas by an appropriate non-uniform mapping of the prediction. For this embodiment with fixed-length-coding and 6. DPCM-bits per sample, there are 64 different code words. So, for HDPCM coding, the predictions have to be mapped on 64 values. It is known by practice that the prediction range is approximately [-128..+127], some so-called "outliers" lying outside this range. Such a said range [-128..+127] could be mapped on 64 values by a division by 4. With negative modulation, a typical range of predictions corresponding to bright image parts is [-16..+15]. If the HDPCM mapping would be a division by 4, only about 8 different output levels of the prediction mapping would be used in bright areas. A typical range of predictions corresponding to dark image parts is [-64..+63]. With a prediction mapping which is a division by 4, about 32 different output levels of the prediction mapping would be used in dark areas. Considering that the probability that transmission errors are corrected rises for an increasing probability that mapped predictions are different in encoder and decoder, a division by 4 leads to a discrepancy of error correction between bright and dark image areas. Therefore, it is preferred to choose for this embodiment the following non-uniform mapping : one-to-one in the range [-16..+15], a division by 5 in the ranges [-96..-17] and [+16..+95], and mapping to -32 for values less than -96 and to +31 for values higher than +95. This preferred mapping is illustrated in Fig. 9 by means of the dashed lines between the scales SCL6 and SCL5. With this non-uniform mapping, about 32 mapping levels are used in bright areas, whereas 52 levels are used in dark areas. This is a ratio of 52/32 for non-uniform mapping instead of 32/8 for a uniform mapping based on a division by 4.

The above described strong error correction for bright image parts through a non-uniform mapping is advantageous in order to obtain a sufficiently correct estimation of the IF carrier phase which is described below.

**Second improving part, named "PCM-bits substitution"**

After the above description of the transport of the MSB's or DPCM-bits applying DPCM (or HDPCM), now follows a description of the transport of the LSB's or PCM-bits.

When the MSB's are coded in DPCM (or HDPCM) and the LSB's are coded in PCM, the LSB's loose their relevance when there is a coding error in the DPCM (or HDPCM) output. A coding error in this embodiment without quantisation is caused by clipping the prediction error. When the prediction error has been clipped, the clipped prediction error is equal to a clipping value, so for this embodiment with 6 DPCM-bits, this is equal to -31 or +30 (or -32 or +31 when the clip range has not been reduced, what is however not preferred). When the decoder of this embodiment receives a prediction error of -31 or +30, the decoder knows without the need for overhead information that clipping has most probably happened. It is only when the unclipped prediction error was exactly -31 or +30 that no clipping has happened.

Consequently, when the transmitted clipped prediction error is +30 or -31, the PCM-bits may be substituted by the amount of the absolute clipping error. This substitution is here and below called a PCM-bits substitution and is an improving part of the invention. With 3 (= M-N) PCM-bits available, an absolute error of up to 7 can be transported as an unsigned integer. It is not necessary to transport a sign, because the decoder knows from the transmitted clipped prediction error the sign of the clipping error. For this embodiment, the sign of the clipping error is positive when the transmitted clipped prediction is +30 (or +31 in case of an unreduced clip range), and negative when the transmitted clipped prediction is -31 (or -32 in case of an unreduced clip range).

A preferred PCM-bits substitution is as follows. If the unclipped prediction error $e_{enc}$ is in the range [+30..+37], the value $e_{enc}$-30 is transmitted in PCM bits; in case of an unreduced clip range, we have respectively the range [+31..+38] and the transmitted value $e_{enc}$-31. If $e_{enc}$ is in the range [-38..-31], the value +31-$e_{enc}$ is transmitted as PCM-bits;

in case of an unreduced clip range, we have respectively the range [-39..-32] and the transmitted value 32-$e_{enc}$. If the prediction error $e_{enc}$ is larger than +37 or smaller than -38 (larger than +38 or smaller than -39 for an unreduced clip range), a value of 7 is transmitted in the PCM-bits.

This is a clipping operation that clips the absolute clipping error to the range [0..7]. The clipping of the prediction errors to the range [-31..+30] in this embodiment (or [-32..+31] for an unreduced clip range) is executed in a first clipper, whereas the clipping of the clipping error to the range [0..7] is executed in a second clipper.

When the decoder at the second location SL receives a clipped prediction error of +30 (+31 for an unreduced clip range), it adds to the output of the DPCM decoder loop the value which is transmitted in the PCM-bits. For a received clipped prediction error of -31 (-32 for an unreduced clip range), the decoder subtracts from the output of the DPCM decoder loop the value which is transmitted in the PCM-bits.

The output of the DPCM decoder loop is $\hat{x}_{dec}+(e_{dec})_c$. The value that is transmitted in the PCM-bits in the case that PCM-bits substitution substitution effectively took place is MAX{$|e-(e_{enc})_c|$,7} in this embodiment with 3 PCM-bits. When the absolute clipping error is less than 8, the output of the decoder is then :

$$\hat{x}_{dec} \; + \; (e_{enc})_c \; + \; (e-(e_{enc})_c)$$

When there have been no transmission errors, the output is then $\hat{x}_{enc}+e$, which is exactly the value of the original sample of the first digitised television IF signal.

When the PCM-bits have been used for the transmission of the absolute clipping error (clipped in its turn to [0..7] in this embodiment), the decoder at the second location SL does not know what should be the value for the LSB's when LSB's and MSB's are combined to an output sample in the combiner. Therefore, at the second location SL, a value of by preference 4 is the three-bit LSB-input of the combiner CB for a sample for which a PCM-bits substitution effectively took place. This reduces the average error in the three LSB's or PCM-bits of a sample with PCM-bits substitution, because they have approximately a uniform distribution in the range [0..7]. The output value of 4 is an arbitrary choice; a value of 3 is a good alternative.

Fig. 11 shows the implementation of PCM-bits substitution. A first location PCM-bits substitution control signal SC1 controls the substitution of PCM-bits. The control signal SC1 is derived in a first location clipping detector BSC1 from the clipped prediction error $(e_{enc})_c$. The control signal SC1 is only true for $(e_{enc})_c$ equal to +30 or -31 (or +31, respectively -32 for an unreduced clip range). In substitutor BS1, the LSB's are replaced by a substitution value CE emanating from the prediction error clipper PEC1 if the control signal SC1 is true.

Fig. 22 is a block diagram of the prediction error clipper PEC1. A first clipper CLP1 clips the prediction error $e_{enc}$. A subtractor SUB13 calculates the clipping error and an absolute value calculator ABS takes the absolute value from it. A second clipper CLP2 clips the absolute clipping error to the range [0..$2^{(M-N)}$-1], generating the substitution value CE, being a clipped absolute clipping error.

A second location PCM-bits substitution control signal SC2 controls an MSB corrector COR and a second location PCM-bits switch BS2. The control signal SC2 and a sign signal SGN are derived in a clipping detector BSC2 from the clipped prediction error $(e_{dec})_c$. The control signal SC2 is true for $(e_{dec})_c$ equal to +30 or -31 (+31 or -32 for an unreduced clip range). The sign signal SGN indicates a positive clipping error if $(e_{dec})c$ is +30 and a negative clipping error if $(e_{dec})_c$ is -31 (+31, respectively -32 for an unreduced clip range).

A second location PCM-bits switch BS2 switches the M-N LSB's of a sample of the second television IF signal between the received M-N bits from the residual bit stream RTS and a fixed replacement (M-N)-bit word $2^{(N-M-1)}$, or 4 in the preferred embodiment. If control signal SC2 indicates that PCM-bits substitution has taken place and if sign signal SGN indicates a positive clipping error, the MSB corrector COR adds the absolute clipping error received via the residual bit stream RTS to the output $\tilde{x}_{dec}$ of the DPCM decoder core D2. Otherwise, for sign signal SGN indicating a negative clipping error in case of PCM-bits substitution, the MSB corrector COR subtracts the absolute clipping error received via RTS from $\tilde{x}_{dec}$ The output of the MSB corrector COR is applied to the combiner CB. . The second improving part, named PCM-bits substitution, has been described above referring to Fig. 11 corresponding to the case whereby DPCM is implemented. Fig. 12 shows a block diagram, illustrating a partial implementation of the first embodiment of this invention, whereby the first and second improvements are combined, HDPCM being implemented for transport of the N most significant bits and PCM-bit substitution being carried out on the M-N least significant bits.

Instead of a clipped absolute clipped error, some other substitution value (CE) which is a function of the clipping error can be used for substitution of the PCM-bits, as long as that substitution value (CE) can be represented by M-N bits. In this case, the decoder has to map by means of a second function the values received as residual transport sample to a value that can be added to or subtracted from the output of the DPCM decoder loop, if the control signal SC2 indicates that PCM-bits substitution has taken place.

**Third improving part, named "dynamic clip range shifting"**

Even with PCM-bits substitution, big clipping errors can still happen at sudden changes of the sampled television IF signal. These coding errors can lead to visible or audible distortions. Fig. 13 and Fig. 14 illustrate such sudden changes of a television IF signal (marked IF). The vertical axis IFL (IF signal level) represents the amplitude of the television IF signal, and the horizontal axis (marked $t$) represents a time axis. Fig. 13 illustrates a television IF signal with negative modulation having at time instant $T_{sc}$ a sudden change (or transition) from a low amplitude (a bright image part) to a high amplitude (a dark image part). Fig. 14 illustrates a television IF signal with negative modulation having at time instant $T_{sc}$ a sudden change (or transition) from a high amplitude (a dark image part) to a low amplitude (a bright image part). Both Fig. 13 and Fig. 14 show samples $S_n$ of the television IF signal each corresponding to a time instant $T_n$. $S_i$, at $T_i$, is the sample taken just before, and $S_{i+1}$, at $T_{i+1}$, the first sample taken just after the sudden change at time instant $T_{sc}$. Graph IFE (with dashed lines) between $T_{sc}$ and $T_{i+1}$ represents the expected television IF signal immediately after $T_{sc}$. $(S_{i+1})_{exp}$ represents the first sample after $T_{sc}$ as it is expected. It is clear from Fig. 13 and Fig. 14 that there is a relatively big prediction error (or $e$) at $T_{i+1}$ between the sample $S_{i+1}$ (or $x$) and the expected (or predicted) sample amplitude $(S_{i+1})_{exp}$ (or $\hat{x}$).

To avoid big clipping errors caused by sudden changes of the sampled television IF signal, an additional improvement is obtained by making the prediction error clip range not fixed but adaptive, applying a method called here dynamic clip range shifting. The said dynamic clip range shifting is related to the phase of the IF carrier and to the luminance of the television IF signal. Therefore, the IF carrier phase and the luminance are estimated in what is further called respectively an IF carrier estimation and a luminance estimation.

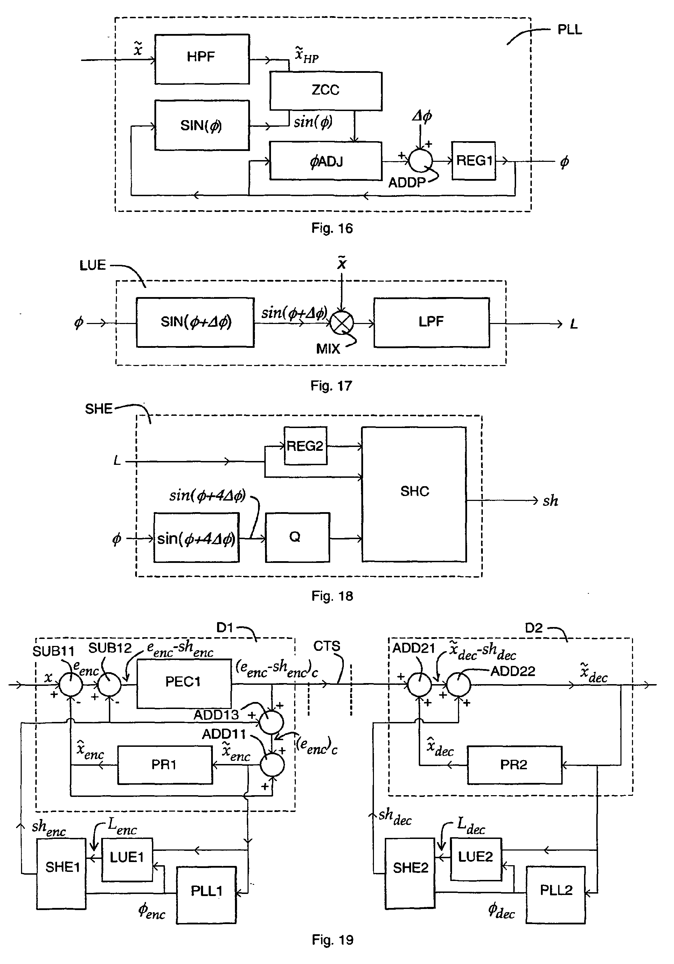

Fig. 15 shows the dynamic clip range shifting added to the elementary set-up, consisting of an IF carrier estimation being a phase-locked loop (PLL1, PLL2), a luminance estimator (LUE1, LUE2) and a shift estimator (SHE1, SHE2) in both the first location FL and the second location SL.

**First divisional part of dynamic clip range shifting, called "IF carrier estimation"**

The dynamic clip range shifting is based on the IF carrier phase. As the IF carrier phase is unknown in the decoder, the decoder has to estimate the IF carrier phase. In order to have the same shift in encoding and decoding with a dynamic clip range shifting, the encoder has to do the same IF carrier estimation as the decoder. The IF carrier estimation is by preference realised by means of a phase-locked loop PLL1, PLL2 , one in the encoder and one in the decoder. In both the encoder and the decoder, it is a decoded television IF signal $\tilde{x}$, respectively being the output $\tilde{x}_{enc}$ of the local decoder in the encoder and the output $\tilde{x}_{dec}$ of the decoder, which is the reference input of the PLL.

The PLL should estimate the phase of the IF carrier present in the decoded television IF signal. In this embodiment, the IF carrier of 38.9 MHz in the spectrum of the digitised PAL B/G television signal is mirrored to a frequency of 38.9-(2*16.2) = 6.5 MHz because of the 16.2 MHz sampling. For other transmission standards (e.g., NTSC M with an IF carrier frequency of 45.75 MHz), the mirrored IF carrier will have a different frequency (e.g., 2.85 Mhz for NTSC M).

In order to reduce the complexity, by preference a simple PLL structure as illustrated in Fig. 16 is implemented, with which the zero-crossings of a signal, further referred to as the generated sine wave $sin(\Phi)$ and being generated by a sine wave generator SIN($\Phi$), are matched to the zero-crossings of the high-pass filtered decoded IF signal $\tilde{x}_{HP}$. The PLL phase $\Phi$ is a linear function of time t, expressed as $\Phi = \omega_{IF}t$ with $\omega_{IF}$ being the angular frequency of the IF carrier. By the said zero-crossings are meant points of time where a zero-mean signal passes from a positive to a negative value or vice-versa.

Because zero-crossings are time-critical for the good operation of the PLL, the decoded IF signal $\tilde{x}$ is first high-pass filtered with a high-pass filter HPF before being applied to a zero-crossing comparator ZCC in order to reduce the influence of the audio signal. On Fig. 4, it is visible in the samples 16500 to 16570 that, for this embodiment for the PAL B/G transmission standard, the audio signal, which is in the spectrum centred around 1 MHz, resembles, referred to the 6.5 MHz IF carrier signal, a relatively slowly varying DC-component which influences significantly the zero-crossings. A simple symmetrical three-taps high-pass filter with taps -1/2/-1 is sufficient and preferred. Such a filter not only suppresses the audio signal around 1 MHz in the digitised IF signal spectrum between 0 and 8.1 MHz, but also the colour information around 6.5-4.43 = 2.07 MHz. In the case of NTSC M, this high-pass filter has to be replaced by a low-pass filter.

The precision of the phase values in the PLL of this embodiment is by preference 8 bit, which means that the phase range of [0°..360°] is to be mapped on the range [0..256]. For a 6.5 MHz sine wave sampled at 16.2 MHz, an increment between two consecutive samples corresponds to a phase increment $\Delta\Phi$ of (256*6.5)/16.2 or approximately 103. For the phase represented by 8 bits, the fixed phase increment is $\Delta\Phi=103$. The phase values are kept within the range [0..255] through a modulo-256 operation, which in a 8-bit-adder happens automatically.

The PLL as shown in Fig. 16 is a loop which consists of a register REG1, an adder ADDP which adds every clock cycle a value $\Delta\Phi$ of 103 to the PLL phase $\Phi$, and extra logic to align the zero-crossings of the high-pass filtered decoded IF signal $\tilde{x}_{HP}$ and the locally generated sine wave $sin(\Phi)$. This extra logic includes the zero-crossing comparator ZCC and a Φ adjustment ΦADJ.

The sign bit of a sine value gives information on the zero-crossings of that sine wave. If, for a given sample, the sign of the high-pass filtered decoded IF signal $\tilde{x}_{HP}$ is equal to the sign of the generated sine wave $sin(\Phi)$, the Φ adjustment ΦADJ passes its input Φ unchanged to its output.

If, for a given sample, the sign of the high-pass filtered decoded IF-signal $\tilde{x}_{HP}$ is not equal to the sign of the generated sine wave $sin(\Phi)$, the PLL phase Φ is adjusted in ΦADJ by the minimum possible amount such that the sign of the high-pass filtered decoded IF-signal $\tilde{x}_{HP}$ and the sign of the generated sine wave $sin(\Phi)$ become the same. Table 1 lists to what values the PLL phase Φ is adjusted in order to obtain an equal sign for the high-pass filtered decoded IF-signal $\tilde{x}_{HP}$ and the generated sine wave $sin(\Phi)$.

The phase adjustment as described here leads to fast recovery of the exact PLL phase Φ in the decoder at start-up or after a transmission error.

In this embodiment, the output of the zero-cross comparator ZCC indicates whether the signs of $\tilde{x}_{HP}$ and $sin(\Phi)$ are identical or not. The Φ-adjustment ΦADJ adjusts the PLL phase Φ according to Table 1, or passes Φ unchanged from input to output if $\tilde{x}_{HP}$ and $sin(\Phi)$ have the same sign.

Table 1

| high-pass filtered decoded IF signal $\tilde{x}_{HP}$ | sine wave $sin(\Phi)$ | PLL phase Φ | PLL phase Φ adjusted to |
|---|---|---|---|
| positive | negative | [128..191] | 127 |
| positive | negative | [192..255] | 256 modulo 256 = 0 |
| negative | positive | [0..63] | (-1) modulo 256 = 255 |
| negative | positive | [64..127] | 128 |

The high-pass filter HPF introduces a phase shift between its output and its input and consequently also a phase shift to the output of the PLL. This phase shift by the high-pass filter HPF must be compensated when the PLL phase Φ is used for decisions on the shift of the clip range. With the here preferred three-tap high-pass filter, the shift introduced by the high-pass filter is one cycle of a sample clock, or 103 units of the 8-bit-precision phase for this embodiment with the PAL B/G transmission standard and a sampling rate of 16.2 MHz.

**Second divisional part of dynamic clip range shifting, called "luminance estimation"**

As said before, the dynamic clip range shifting is not only related to the phase of the IF carrier, but also to the luminance of the composite signal that modulates the IF carrier. The luminance is however not transmitted as side information within the sampled television IF-signal and must therefore be estimated in both the encoder and the decoder. In order to have the same shift in encoding and decoding with a dynamic clip range, the encoder must have the same luminance estimation as the decoder.

A television IF signal is approximately an IF carrier which is modulated in amplitude by the luminance, and is represented here further as $Y*sin(\omega_{IF}t)$ whereby Y is the luminance and whereby $\omega_{IF}$ is the angular frequency of the IF carrier. After sampling at 16.2 MHz, the IF carrier frequency is mirrored to the range [-8.1..+8.1 MHz].

The luminance estimation is by preference carried out in two steps as described below.

The first step of the luminance estimation is the multiplication of the output signal X of the decoder or of the local decoder in the encoder by an estimated IF carrier. The estimated IF carrier is derived from the PLL phase Φ.

The output Φ of the PLL has a phase delay of one sample period with respect to the decoded IF signal $\tilde{x}$ because of the delay caused by the three-taps high-pass filter HPF in the PLL. The said phase delay of one sample period is compensated for in the luminance estimation by not multiplying $sin(\Phi)$ but $sin(\Phi+\Delta\Phi)$ with $\tilde{x}$, $sin(\Phi+\Delta\Phi)$ being $sin(\Phi+103)$ for PAL B/G. So, $sin(\Phi+\Delta\Phi)$ is an estimation for IF carrier $sin(\omega_{IF}*t)$. The multiplication is then :

$$\tilde{x} *sin(\omega_{IF}*t) \approx Y*sin(\omega_{IF}*t)*sin(\omega_{IF}*t) = 0.5*Y*(1-cos(2\omega_{IF}*t))$$

The second step of the luminance estimation is a low-pass filtering by means of a low-pass filter LPF of the result of the multiplication of the first step of the luminance estimation in order to suppress the high-frequency component $cos(2\omega_{IF}*t)$ and to obtain the luminance Y, being an estimated luminance L.

The output of the mixing of the decoded IF signal X and the sine wave $sin(\Phi+\Delta\Phi)$ has a strong component at the double IF carrier frequency. With this embodiment for PAL B/G, the said double IF carrier frequency is 6.5*2 or 13 MHz. Because of the 16.2 MHz sampling frequency, there is a mirroring of the 13 MHz mixing component at 16.2-13 or 3.2 MHz, a frequency which corresponds to approximately a complete cycle of five sample periods (3.2/16.2 is approximately 1/5). Therefore, the said low-pass filtering of the second step of the luminance estimation is by preference a 5-tap moving-average filter for PAL B/G. A moving-average filter without multipliers is preferred because of its simple realisation, and because it almost completely suppresses the unwanted mixing output of 3.2 MHz.

Fig. 17 shows a block diagram of the luminance estimation part (marked LUE) of this embodiment of the invention as described above, with which the estimated luminance $L$ is obtained from the PLL phase $\Phi$ and the decoded IF signal $\tilde{x}$. The said multiplication of the first step of the luminance estimation is carried out as a mixing in a mixer MIX of the decoded IF signal X with a local oscillator sine wave $sin(\Phi+\Delta\Phi)$ from a local oscillator $SIN(\Phi+\Delta\Phi)$. The output of low-pass filter LPF is the estimated luminance $L$ and is the sum of the actual and the previous four inputs.

**Third divisional part of dynamic clip range shifting is described now, named "shift calculation"**

A preferred calculation of a shift of the clip range is described, based on the IF carrier phase and luminance estimations described above.

Prediction errors can lie outside the clip range at unpredictable sudden changes or transitions of the television IF signal, of which some have been described before with the aid of Fig. 13 and Fig. 14. In the sampled television IF signal, these said sudden changes are maximal when a difficult to predict sample coincides with a peak of the sine wave of the IF carrier. Therefore, a shift of the clip range ([-31..+30] for this embodiment) must be in proportion to the instantaneous value of the sine wave of the IF carrier which can be represented as $sin(\omega_{IF}*t)$.

Table 2

| Instantaneous value of the IF carrier $sin(\omega_{IF}*t)$ | shift amount at low luminance | shift amount at high luminance |
|---|---|---|
| $256*sin(\omega_{IF}*t) \leq -96$ | +12 | -12 |
| $-96 < 256*sin(\omega_{IF}*t) \leq -80$ | +8 | -8 |
| $-80 < 256*sin(\omega_{IF}*t) \leq -64$ | +4 | -4 |
| $-64 < 256*sin(\omega_{IF}*t) < 64$ | 0 | 0 |
| $64 \leq 256*sin(\omega_{IF}*t) < 80$ | -4 | +4 |
| $80 \leq 256*sin(\omega_{IF}*t) < 96$ | -8 | +8 |
| $96 \leq 256*sin(\omega_{IF}*t)$ | -12 | +12 |

In order to avoid a multiplication in the calculation of the shift $sh$ of the clip range as represented by

$$sh(t) = C*sin(\omega_{IF}*t)$$

whereby C is an arbitrary constant, the estimated IF carrier is quantised. A preferred implementation uses seven levels of quantisation.

The preferred thresholds for the 7-level quantisation are given in the first column of Table 2.

The amount of shift of the prediction error clip range is by preference determined as follows.

When the luminance is low, a hardly predictable transition is a transition to a high luminance. When the first sample of the IF signal after such a transition from a low to a high luminance coincides with a positive peak of the IF carrier as illustrated in Fig. 14, the prediction error will have a large negative value, for some transitions of this embodiment much less than -31. Therefore, the losslessness of the compression in case of hardly predictable luminance transitions is improved by introducing a shift $sh$ of the before mentioned clip range of [-31..+30] for samples corresponding to a dark luminance to a clip range of [(-31+$sh$)..(30+$sh$)] whereby $sh$ is a negative value of by preference 0, -4, -8 or -12, corresponding respectively to the before mentioned quantisation levels of the instantaneous value of the IF carrier as indicated in Table 2. When the first sample of the IF signal after such a transition from a low to a high luminance coincides with a negative peak of the IF carrier, the shift should have a positive value, for this embodiment by preference with $sh$ values of 0, +4, +8 and +12 corresponding to the quantisation levels of the quantised instantaneous value of the estimated IF carrier as indicated in Table 2. In Fig. 9, SCL9 illustrates a shift of the clip range [-32..+31] for a shift $sh$ of +8.

When the luminance is high, a hardly predictable transition is a transition to a low luminance. Similarly as with the above described transition from a low to a high luminance, coding errors are reduced by a shift $sh$ of the clip range.

When the first sample of the IF signal after such a transition from a high to a low luminance coincides with a positive peak of the IF carrier as illustrated in Fig. 13, a positive shift *sh* of the clip range is needed. When the first sample of the IF signal after a transition from a high to a low luminance coincides with a negative peak of the IF carrier, a negative shift *sh* of the clip range is needed. Table 2 shows the preferred shift amounts for this embodiment in function of the quantised instantaneous value of the estimated IF carrier.

**Improvement to the shift calculation, named "dejitter"**

Practice has shown that it is preferred to add some dejitter to the thresholds of the low and high luminance values of the estimated luminance *L*. With this embodiment, the dejitter is obtained by taking into account both the estimated luminance of the actual sample and the estimated luminance of the previous sample. A sample is considered to belong to a low luminance area if the estimated luminance *L* of that sample is less than 8 and the estimated luminance *L* of the previous sample is less than 8-2 or 6. Similarly, a sample is determined to belong to a high luminance area if the estimated luminance *L* of that sample is higher than 12 and the estimated luminance *L* of the previous sample is higher than 12+2 or 14. The just mentioned thresholds of low and high luminance are given here as an example but depend on the reference voltage used for the analog-to-digital conversion of the television IF signal. The estimated luminances change in accordance with a change of the reference voltage.

The shift of the clip range for a given sample depends on the level of the quantised IF carrier. That quantised IF carrier depends on the PLL phase Φ from the phase-locked loop PLL. The phase used to decide on the shift of the clip range contains compensation for a number of delays. These delays are illustrated in Fig. 20. Fig. 20 shows five graphs G1, G2, G3, G4 and G5. Graph G1 is used as time reference for the other graphs of the same figure and shows a block signal with a period (sampling period $T_s$) and phase corresponding to the sampling rate of the samples *x*. Graph G2 represents the consecutive incoming samples $x_i$, $x_{i+1}$, ... Graphs G3, G4 and G5 illustrate the following delays :

- a two-sample delay between the shift of the clip range of the prediction errors and the DPCM output (this delay depends on the implementation of the DPCM loops), illustrated in graph G3;
- a one-sample delay caused by the three-tap high-pass filter HPF in the PLL, illustrated in graph G4;
- a one-sample delay between the calculation of the shift amount and the actual shifting of the clip range, illustrated in graph G5 (this delay too depends on the implementation of the embodiment).

For the considered implementation, there is a compensation for a total delay of four samples. Therefore, the sine wave used for the decision on the shift of the clip range is for this embodiment expressed by $sin(\Phi+4\Delta\Phi)$ or $sin(\Phi+4*(256*6.5/16.2))$, which is $sin(\Phi+411)$ for an 8-bit representation of the phase.

Fig. 18 shows a block diagram of the shift estimator (marked SHE) of this embodiment of the invention as described above, with which the shift *sh* is obtained from the PLL phase Φ and the estimated luminance *L*. From the PLL phase Φ, a sine wave $sin(\Phi+4\Delta\Phi)$ is generated with a sine wave generator SIN($\Phi+4\Delta\Phi$). The sine wave $sin(\Phi+4\Delta\Phi)$ is quantised in a 7-level quantizer Q of which the output is applied to a shift calculator SHC. In the shift calculator SHC, the amount of shift *sh* of the prediction error clip range is determined as described above.

The implementation of the dejitter in this embodiment includes a register REG2 which delays the estimated luminance *L* of a sample for the duration of one sample.

The dynamic clip range shifting is by preference implemented in three consecutive steps.

- subtract the shift from the prediction error, what results in a shifted prediction error;
- clip the shifted prediction error to a fixed clip range, for this embodiment to the range [-31..+30] (or [-32..+31] in the case of unreduced clip range), what results in a clipped shifted prediction error;
- add the shift amount to the clipped shifted prediction error.

Fig. 19 illustrates the implementation of the dynamic clip range shifting. At the first location, a subtractor SUB12 subtracts the shift $sh_{enc}$ from the prediction error $e_{enc}$, resulting in a shifted prediction error $e_{enc}$-$sh_{enc}$. The shifted prediction error $e_{enc}$-$sh_{enc}$ is clipped in the prediction error clipper PEC1 and results in a clipped shifted prediction error $(e_{enc}$-$sh_{enc})_c$. The shift $sh_{enc}$ is added by adder ADD13 to the clipped shifted prediction error $(e_{enc}$-$sh_{enc})_c$ and the resulting sum $(e_{enc})_c$ is added by adder ADD11 to the encoder prediction $\hat{x}_{enc}$ to result in the output $\tilde{x}_{enc}$ of the local decoder in the encoder. At the second location, the shift $sh_{dec}$ is added in an adder ADD22 to the shifted decoder output $\tilde{x}_{dec}$-$sh_{dec}$ resulting in the decoder output $\tilde{x}_{dec}$.

HDPCM is not implemented in Fig. 19; it is however possible to combine the dynamic clip range shifting with HDPCM as described before because the range of transmitted prediction errors remains [-31..+30]. Fig. 5, which is a complete implementation of this embodiment, shows HDPCM combined with dynamic clip range shifting.

The above described first embodiment of the present invention can be implemented in a field programmable logic gate array, by preference working at a clock frequency equal to the sampling frequency of the first digitised television IF frequency.

Although the present invention has been described with reference to the first embodiment of the present invention, the invention is not limited solely to this first embodiment. Digitised television IF signals according to the same or other transmission standards than the one mentioned in the description of the first embodiment, may be transported over the same or other transport channels than the one mentioned in the said description, the prediction and the dynamic clip range shifting being adapted to the transmission standard. Another digital signal than a digitised television IF signal can also be transported, again with the prediction and the dynamic clip range shifting being adapted to the parameters of the digital signal. Other values can be chosen for M, N and C. Moreover, various other preferred choices in the implementation of the first embodiment of the present invention can be made differently.

The first embodiment of the present invention has been described above starting from the implementation of an elementary implementation with reference to Fig. 6, and followed by a step-by-step addition of improving parts to a full implementation shown in Fig. 5. By the improving parts is thereby meant HDPCM, PCM-bit substitution and dynamic clip range shifting.

The invention can, at the expense of a lower grade transport of the digital signal or at the expense of a higher probability for coding errors, be implemented as a combination of the elementary implementation as described in the description of the first embodiment and one or more but not all of the improving parts described in the description of the first embodiment. The below described second and third embodiments of the present invention are two examples of combinations of the elementary implementation and one or more of the improving parts.

**Second preferred embodiment**

The second embodiment of the present invention is a method for the transport of a sample S1 of a first digital signal over a transport channel TC from a first location FL to a second location SL, where it is received as a sample S2 of a second digital signal. The to be transported digital signal and transport channel TC are in particular (but not necessarily) the same as described in the first embodiment, the to be transported digital signal thus being a digitised television IF signal.

The second embodiment is described below with reference to and compared to the description of the first embodiment of this invention and the figures used for it.

Fig. 21 shows a block diagram of the implementation of the second embodiment. The second embodiment is characterised in that the M-N LSB's are transmitted uncompressed, by preference in PCM, and that the N MSB's are compressed to N-C bits by implementation of the improving part HDPCM with the HDPCM extra-improving part "reduction of the clip range" and/or the HDPCM extra improving part "non-uniform-mapping". In the block diagram of Fig. 21 is thus combined the elementary set-up of Fig. 6 with HDPCM as illustrated in Fig. 10; the extra-improving parts are not visible in Fig. 21.

For a more detailed description of this second embodiment is referred to the description of the first embodiment, wherein all the parts of this second embodiment are described.

**Third preferred embodiment**

The third embodiment of the present invention is a method for the transport of a sample S1 of a first digital signal over a transport channel TC from a first location FL to a second location SL, where it is received as a sample S2 of a second digital signal. The to be transported digital signal and transport channel TC are in particular (but not necessarily) the same as described in the first embodiment, the to be transported digital signal thus being a digitised television IF signal.

The third embodiment is described below with reference to and compared to the description of the first embodiment of this invention and the figures used for it.

Fig. 15, already referred to in the description of the first embodiment, shows a block diagram of the implementation of the third embodiment. The third embodiment is characterised in that the M-N LSB's are transmitted uncompressed, by preference in PCM, and that the N MSB's are compressed to N-C bits by implementation of the improving part "dynamic clip range shifting". In the block diagram of Fig. 15 is thus combined the elementary set-up of Fig. 6 with dynamic clip range shifting as illustrated in Fig. 19.

For a more detailed description of this third embodiment is referred to the description of the first embodiment, wherein all the parts of this third embodiment are described.

Reference key :

Reference sign Designation of indicated feature

| Reference sign | Designation of indicated feature |
|---|---|
| ABS | absolute value calculator |
| AD | analog-to-digital converter |
| ADD... | adder ... |
| ADDP | adder in PLL |
| AS1 | first analog signal |
| AS2 | second analog signal |
| BS1 | first location substitutor |
| BS2 | second location substitutor |
| BSC1 | first location clipping detector |
| BSC2 | second location clipping detector |
| c | clipped (index), also noted as $(...)_c$ |
| CB | combiner |
| CE | substitution value |
| CLP | clipper |
| COR | PCM-bit substitution MSB corrector |
| CTS | compressed transport sample |
| D1 | encoder DPCM-core |
| D2 | decoder DPCM-core |
| dec | of decoder (index) |
| D1 | encoder DPCM-core |
| D2 | decoder DPCM-core |
| DA | digital-to-analog converter |
| DS1 | first digital signal |
| DS2 | second digital signal |
| e | prediction error |
| enc | of encoder (index) |
| f | frequency (axis) |
| FL | first location |
| Φ | PLL phase |
| ΦADJ | Φ-adjustment |
| G1 ... G5 | graph 1 ... graph 5 |
| H(f) | spectrum amplitude (axis) |
| HPF | high-pass filter |
| IFL | If signal level |
| L | estimated luminance |
| LSB | least significant bits (PCM-bits) |
| LP11 | first loop of the encoder |
| LP12 | second loop of the decoder |
| LP21 | loop of the decoder |
| LUE | luminance estimator |
| m (...) | mapped value of (...) |
| MIX | mixer |
| MSB | most significant bits (DPCM-bits) |
| PEC | prediction error clipper |
| PLL | phase-locked loop |
| PM | prediction mapper |
| PR | predictor |
| Q | quantizer |
| Q&CL | quantizer and clipper |
| REC | receiver |

(continued)

Reference sign Designation of indicated feature

| | |
|---|---|
| REG1 | register (in PLL) |
| REG2 | register (in shift estimator) |
| RTS | residual transport sample |
| S1 | sample of the first digital signal (sample of a digitised television IF signal in the embodiments) |
| S2 | sample of the second digital signal (sample of a digitised television IF signal in the embodiments) |
| SC1 | first location PCM-bit substitution control signal |
| SC2 | second location PCM-bit substitution control signal |
| SCL... | scale ... |
| *sh* | shift (of the clip range) |
| SGN | sign signal |
| SHC | shift calculator |
| SHE | shift estimator |
| $S_i$ | i-th sample of the television IF signal |
| SL | second location |
| SN | sample number (axis) |
| $S_n$ | n-th sample of the television IF signal |
| SP | splitter |
| SUB | subtractor |
| SV | sample value (axis) |
| t | time (axis) |
| TRA | transmitter |
| TC | transport channel |
| TCBS | transport channel bit-stream |
| $T_s$ | sampling period |
| VLC | variable length coder |
| VLD | variable length decoder |
| *wr*(...) | wrapped-around value of (...) |
| *x* | sample (of a digital signal to be transported) |
| $\hat{x}$ | prediction (of a decoder, or of a local decoder in an encoder) |
| $\tilde{x}$ | output signal(of a decoder, or of a local decoder in an encoder) |
| ZCC | zero-cross comparator |

## Claims

1. Method for the transmission of a first digital signal (DS1) from a first location (FL) over a transport channel (TC) to one or more second locations (SL) where it is received as a second digital signal (DS2) which is substantially equal to the first digital signal (DS1), whereby a sample (S1) of the first digital signal (DS1) represented by M bits, being the total of N most significant bits (MSB) and M-N least significant bits (LSB), is transported over the transport channel (TC) as a transport sample comprising at least two parts, of which

   - one part is a compressed transport sample (CTS) represented by N-C bits, N being smaller than M and C being smaller than N and larger than 0, the N-C bits being obtained through predictive coding of the N most significant bits of the sample (S1) of the first digital signal (DS1), whereby to each sample (S1) of the first digital signal (DS1) corresponds at least

   a prediction ($\hat{x}_{enc}$), *based on previously compressed samples and* representing the predicted N most significant bits of the sample (S1) of the first digital signal (DS1),
   a prediction error ($e_{enc}$) representing the difference between the N most significant bits of the sample (S1) of the first digital signal (DS1) and the said prediction ($\hat{x}_{enc}$),
   and a clipping error representing the difference between the prediction error ($e_{enc}$) and a clipped prediction error $(e_{enc})_c$ which is the prediction error clipped by a first clipper (PEC1) to a clip range represented as [A..B] by means of N-C bits, A and B being integers and B-A being equal to or smaller than 2<(N-C)>-1, and

- the other part is a residual transport sample (RTS) represented by M-N bits,

**characterised in that** the said residual transport sample (RTS) is either equal to the M-N least significant bits (LSB) of the said sample (S1) of the first digital signal (DS1) in the case that the prediction error $(e_{enc})$ corresponding to the said sample (S1) of the first digital signal (DS1) is in the range [A..B], or, in the other case, it is equal to a substitution value (CE) which is a function of the clipping error corresponding to the said sample (S1) of the first digital signal (DS1), whereby the output value of the said function of the clipping error can be represented by M-N bits.

2. Method according to claim 1, **characterised in that** the compressed transport sample (CTS) is the clipped prediction error $((e_{enc})_c)$.

3. Method according to claim 1, **characterised in that** the compressed transport sample (CTS) is an in the range [A..B] wrapped around sum of the clipped prediction error $((e_{enc})_c)$ and a mapped value $(m(\hat{x}_{enc}))$ of the prediction $(\hat{x}_{enc})$, and that the said mapped value $(m(\hat{x}_{enc}))$ of the prediction $(\hat{x}_{enc})$ is the prediction $(\hat{x}_{enc})$ mapped on a range [D..E], E and D being integers and E-D being equal to or smaller than $2^{(N-C)}-1$.

4. Method according to any of the previous claims, **characterised in that** the residual transport signal (RTS) is transported in PCM.

5. Method according to any of the above claims, **characterised in that**, in the case that the prediction error $(e_{enc})$ corresponding to the said sample (S1) of the first digital signal (DS1) is not in the range [A..B], the said substitution value (CE) is obtained by first taking the absolute value of the clipping error of the said sample (S1) of the first digital signal (DS1), and then clipping the said absolute value to a range which can be represented by M-N bits.

6. Method for the transmission of a first digital signal (DS1) from a first location (FL) over a transport channel (TC) to one or more second locations (SL) where it is received as a second digital signal (DS2) which is substantially equal to the first digital signal (DS1), whereby a sample (S1) of the first digital signal (DS1) represented by N bits, is transported over the transport channel (TC) as a transport sample represented by N-C bits, C being smaller than N and larger than 0, the N-C bits being obtained through predictive coding of the N bits of the sample (S1) of the first digital signal (DS1), whereby with each sample of the first digital signal (DS1) corresponds at least a prediction $(\hat{x}_{enc})$ representing the predicted N bits of the sample (S1) of the first digital signal (DS1), whereby the prediction is based on previously compressed samples, and a prediction error $(e_{enc})$ representing the difference between the N bits of the sample (S1) of the first digital signal (DS1) and the said prediction $(\hat{x}_{enc})$, **characterised in that** the transport sample is an in the range [A..B] wrapped around sum of the prediction error $(e_{enc})$ clipped to a range named clip range [A..B], A and B being integers and B-A being equal to $2^{(N-C)}-1$, and a mapped value $(m(\hat{x}_{enc}))$ of the prediction $(\hat{x}_{enc})$ which has been mapped on a range [D..E], E and D being integers and E-D being equal to or smaller than $2^{(N-C)}-1$.

7. Method according to claim 3 or 6, **characterised in that** the prediction $(\hat{x}_{enc})$ is mapped or quantised in a non-uniform way, such that the quantisation is fine for prediction values corresponding to small input amplitudes and rough for prediction values corresponding to big amplitudes of the first digital signal.

8. Method according to any of the previous claims, **characterised in that** for the clip range [A..B], B-A is smaller than $2^{(N-C)}-1$.

9. Method according to any of the previous claims, **characterised in that** the clip range [A..B] is fixed (being not shiftable) for all samples.

10. Method according to any of claims 1 to 8, **characterised in that** the clip range [A..B] is shiftable in every sample over a shift $(sh)$, the shift $(sh)$ in a sample being a function of one or more actual parameters of the said sample of the first digital signal, the clip range then being [A+sh..B+sh].

11. Method for the transmission of a first digital signal (DS1) from a first location (FL) over a transport channel (TC) to one or more second locations (SL) where it is received as a second digital signal (SL) which is substantially equal to the first digital signal (DS1), whereby a sample (S1) of the first digital signal (DS1), represented by N bits, is transported over the transport channel (TC) as a transport sample represented by N-C bits, C being smaller than N and larger than 0, the N-C bits being obtained through predictive coding of the N bits of the sample (S1) of the first digital signal (DS1), whereby with each sample (S1) of the first digital signal (DS1) corresponds at least a prediction ($\hat{x}_{enc}$) representing the predicted N bits of the sample (S1) of the first digital signal (DS1), whereby the prediction ($\hat{x}_{enc}$) is based on previously compressed samples, and a prediction error ($e_{enc}$) representing the difference between the N bits of the sample (S1) of the first digital signal (DS1) and the said prediction ($\hat{x}_{enc}$), and whereby the transport sample is the prediction error ($e_{enc}$) clipped to a range named clip range, which can be represented by means of N-C bits, **characterised in that** the clip range is shiftable in function of one or more actual parameters of the first digital signal.

**12.** Method according to one of the previous claims, whereby the first digital signal (DS1) is a digitised television IF signal, the second digital signal (DS2) consequently also being a digitised television IF signal.

**13.** Method according to any of claims 1 to 8 or 10 to 11, whereby the first digital signal (DS1) is a digitised television IF signal with an IF carrier and featuring as parameters at least an estimated luminance and an estimated IF carrier phase, the second digital signal (DS2) consequently also being a digitised television IF signal, **characterised in that**

- the clip range [A..B] is shifted over a shift (*sh*) to [A+*sh*..B+*sh*], whereby the shift (*sh*) for a sample is determined by the estimated luminance and/or by the estimated IF carrier phase **in that** sample,
- the absolute amount of the shift (*sh*) is proportional to the absolute value of the amplitude of the estimated IF carrier,
- for a television IF signal with negative modulation, either the shift (*sh*) is negative in case of a positive peak of the estimated IF carrier and a low luminance, and in case of a negative peak of the estimated IF carrier and a high luminance, or the shift (*sh*) is positive in case of a negative peak of the estimated IF carrier and a low luminance, and in case of a positive peak of the estimated IF carrier and a high luminance,
- for a television IF signal with positive modulation, either the shift (*sh*) is positive in case of a positive peak of the estimated IF carrier and a low luminance, and in case of a negative peak of the estimated IF carrier and a high luminance, or the shift (*sh*) is negative in case of a negative peak of the estimated IF carrier and a low luminance, and in case of a positive peak of the estimated IF carrier and a high luminance.

**14.** Method according to claim 13, whereby at the first location, there is an encoder for predictive coding of a part or all of the bits of a sample, and whereby at each second location (SL) there is a decoder for decoding the predictively coded bits of a sample, and whereby the encoder contains a local decoder to locally decode the transmitted predictively coded bits of a sample, **characterised in that** in order to estimate the luminance in the first and in the second locations, the IF carrier is first estimated at both first and second locations, and then multiplied at the first location (FL) with the output of a local decoder and at the second location (SL) with the output of a decoder, and finally low-pass filtered at both first and second locations.

**15.** Method according to any of claims 13 or 14, **characterised in that** in order to estimate the IF carrier in the first and the second locations, the output of a local decoder at the first location or the output of the decoder at the second locations is first band-pass filtered and then at both locations, the output of the band-pass filter is the input of a phase-locked loop which tracks the phase of the IF carrier.

**16.** Transmitting apparatus for transforming a digitised television IF signal is into a transport channel bit-stream (TCBS) for transmission of the said digitised television IF signal from a first location (FL) to one or more second locations (SL) comprising
a splitter (SP) for splitting a sample (S1) of the said digitised television IF signal into N most significant bits (MSB) and M-N least significant bits (LSB),
an encoder DPCM-core (D1) for compression of the N most significant bits (MSB) of a sample (S1) into a N-C-bit compressed transport sample (CTS), generating a clipped prediction error ($e_{enc}$)$_c$ and
an output for the transport channel bit-stream (TCBS), **characterised in that** it furthermore comprises
a first location clipping detector (BSC1) for generating a first location PCM-bits substitution control signal (SC1) indicating what is to be transmitted as residual transport sample (RTS), either the M-N least significant bits (LSB) of the sample S1 of the first digitised television IF signal, or a substitution value (CE) being a first function of the clipping error corresponding to the said sample S1 of the first digitised television IF signal, and
a first location substitutor (BS1) for substituting the M-N least significant bits (LSB) by a substitution value (CE), depending on the value of the first location PCM-bits substitution control signal (SC1).

**17.** Transmitting apparatus according to claim 16, **characterised in that** it also comprises

- a prediction mapper (PM1) for generating a mapped prediction ($m(\hat{x}_{enc})$) from an encoder prediction ($\hat{x}_{enc}$) from the encoder DPCM-core (D1), and
- an adder (ADD12) which adds the mapped prediction ($m(\hat{x}_{enc})$) and the clipped prediction error ($(e_{enc})_c$), and then wraps around the result of the addition, thus obtaining a compressed transport sample (CTS), and **in that**
- the encoder DPCM-core (D1) comprises means to clip the prediction errors to a range smaller than $2^{(N-C)}-1$, and/or
- the prediction mapper (PM1) comprises means for a non-uniform mapping.

**18.** Transmitting apparatus for transforming a digitised television IF signal is into a transport channel bit-stream (TCBS) for transmission of the said digitised television IF signal from a first location (FL) to one or more second locations (SL) comprising

an encoder DPCM-core (D1) for compression of a sample S1 of the first digitised television IF signal, represented by N bits, into a N-C-bit compressed transport sample (CTS), generating a prediction ($\hat{x}_{enc}$) and a clipped prediction error ($e_{enc})_c$ and
an output for the transport channel bit-stream (TCBS),
**characterised in that** it furthermore comprises
a prediction mapper (PM1) for generating a mapped prediction $m(\hat{x}_{enc})$ from the prediction $\hat{x}_{enc}$ from the encoder DPCM-core (D1), and
an adder (ADD12) for adding the mapped prediction $m(\hat{x}_{enc})$ and the clipped prediction error ($(e_{enc})_c$), and then for wrapping around the result of the addition, thus obtaining a compressed transport sample (CTS), and **in that**
the encoder DPCM-core (D1) comprises means to clip the prediction errors to a range smaller than $2^{(N-C)}-1$, and/or
the prediction mapper (PM1) comprises means for a non-uniform mapping.

**19.** Transmitting apparatus according to any of the claims 16, 17 or 18, **characterised in that** it also comprises

- a phase-locked loop (PLL1) which estimates the phase ($\Phi_{enc}$) of the IF carrier of the digitised television IF signal, based on a locally decoded television IF signal ($\tilde{x}_{enc}$) from the encoder DPCM-core (D1),
- a luminance estimator (LUE1) which estimates the luminance of the video signal contained in the digitised television IF signal, based on the decoded television IF signal ($\tilde{x}_{enc}$) and on the estimated phase ($\Phi_{enc}$) of the IF carrier, resulting in an estimated luminance ($L_{enc}$), and
- a shift estimator (SHE1) which estimates a shift ($sh_{enc}$), based on the estimated phase ($\Phi_{enc}$) of the IF carrier and on the estimated luminance ($L_{enc}$),

and **in that** the encoder DPCM-core comprises means to clip the prediction error ($e_{enc}$) to a range which is shifted over a shift ($sh_{enc}$).

**20.** Transmitting apparatus for transforming a digitised television IF signal into a transport channel bit-stream (TCBS) for transmission of the said digitised television IF signal from a first location (FL) to one or more second locations (SL), comprising

an encoder DPCM-core (D1) for compression of a sample (S1) of the first digitised television IF signal, represented by N bits, into a N-C-bit compressed transport sample (CTS), generating a prediction ($\hat{x}_{enc}$) and a clipped prediction error, ($e_{enc})_c$ and
an output for the transport channel bit-stream (TCBS),
**characterised in that** it furthermore comprises
a phase-locked loop (PLL1) for estimating the phase ($\Phi_{enc}$) of the IF carrier of the digitised television IF signal, based on a locally decoded television IF signal $\tilde{x}_{enc}$) from the encoder DPCM-core (D1),
a luminance estimator (LUE1) for estimating the luminance of the video signal contained in the digitised television IF signal, based on the decoded television IF signal ($\tilde{x}_{enc}$) and on the estimated phase ($\Phi_{enc}$) of the IF carrier, resulting in an estimated luminance ($L_{enc}$), and
a shift estimator (SHE1) for estimating a shift ($sh_{enc}$), based on the estimated phase ($\Phi_{enc}$) of the IF carrier and on the estimated luminance ($L_{enc}$)
and **in that** the encoder DPCM-core comprises means to clip the prediction error ($e_{enc}$) to a range which is shifted over a shift ($sh_{enc}$).

**21.** Receiving apparatus for transforming a transport channel bit-stream (TCBS), which contains a first digitised television IF signal represented by transport samples composed of at least a N-C-bits compressed transport sample (CTS) and a M-N-bits residual transport sample (RTS) and which is transmitted with an apparatus according to claim 16, 17 or 19, into a second digitised television IF signal comprising

an input for the transport channel bit-stream (TCBS), -
a decoder DPCM-core (D2) for decompressing the N-C bits of a a compressed transport sample (CTS) to N MSB's of an output sample (S2), and
a combiner (CB)
**characterised in that** it furthermore comprises
a second location clipping detector (BSC2) for generating a second location PCM-bits substitution control signal (SC2), indicating what is to be selected as M-N least significant bits of the output sample (S2), and a sign signal (SGN), being the sign bit of the transmitted transformed clipping error,
a second location substitutor (BS2) for switching between the received M-N LSB's from the residual transport sample (RTS) and a fixed replacement according to the second location PCM-bits substitution control signal (SC2), and
a MSB corrector (COR) for adding to or subtracting from the output of the decoder DPCM-core (D2) the output value of mapping the received transport sample (RTS) by means of a second function, according to the second location PCM-bits substitution control signal (SC2) and the sign signal (SGN).
*whereby the combiner having means for combining into an output sample (S2) the N MSB's of a sample with the M-N bits residual transport sample or with said fixed replacement.*

**22.** Receiving apparatus according to claim 21 **characterised in that** it also comprises

- a prediction mapper (PM2) for generating a mapped prediction ($m(\hat{x}_{dec})$) from a decoder prediction ($\hat{x}_{dec}$) from the decoder DPCM-core (D2), whereby the prediction mapper (PM2) comprises means for a non-uniform mapping, and
- a subtractor (SUB21) which subtracts the mapped prediction ($m(\hat{x}_{dec})$) from the sample of the compressed transport stream (CTS) and which then does a wrap-around of the result of the subtraction, obtaining so a clipped prediction error ($(e_{dec})_c$).

**23.** Receiving apparatus for transforming a transport channel bit-stream (TCBS), containing a first digitised television IF signal represented by transport samples composed of at least a N-C-bits compressed transport sample (CTS) and being transmitted with an apparatus according to claim 18 or 19, into a second digitised television IF signal comprising:

an input for the transport channel bit-stream (TCBS),
a decoder DPCM-core (D2)

**characterised in that** it furthermore comprises
a prediction mapper (PM2) for generating a mapped prediction ($m(\hat{x}_{dec})$ from a decoder prediction ($\hat{x}_{dec}$) from the decoder DPCM-core (D2), whereby the H prediction mapper (PM2) comprises means for a non-uniform mapping , and
a subtracter (SUB21) for subtracting the mapped prediction ($m(\hat{x}_{dec})$) from the sample of the compressed transport stream (CTS) and for the wrapping around the result of the subtraction, obtaining so a clipped prediction error ($e_{dec})_c$) *whereby the decoder DPCM-core (D2) having means for decompressing the N-C bits of said clipped prediction error $(e_{dec})_c$) to N bits of an output sample (S2).*

**24.** Receiving apparatus according to any of claims 21, 22 or 23, **characterised in that** it also comprises

- a phase-locked loop (PLL2) which estimates a phase ($\Phi_{dec}$) of the IF carrier based on a decoded television IF signal ($\tilde{x}_{dec}$) from the decoder DPCM-core (D2),
- a luminance estimator (LUE2) which estimates the luminance of the video signal contained in the television IF signal based on the decoded television IF signal ($\tilde{x}_{dec}$) and on the said estimated phase ($\Phi_{dec}$) of the IF carrier, resulting in an estimated luminance ($L_{dec}$),
- a shift estimator (SHE2) which estimates the amount of shift ($sh_{dec}$) based on the said estimated phase ($\Phi_{dec}$) of the IF carrier and on the said estimated luminance ($L_{dec}$),

and **in that** the decoder DPCM-core (D2) comprises means to decode prediction errors which have been clipped in the encoder at the corresponding transmitting apparatus to a clip range which has been shifted there by an amount indicated by a shift estimator (SHE1).

**25.** Receiving apparatus for transforming a transport channel bit-stream (TCBS), containing a first digitised television IF signal represented by transport samples composed of at least a N-C-bits compressed transport sample (CTS) and being transmitted by an apparatus according to claim 20, into a second digitised television IF signal by a method corresponding to the method of compression of the said first digitised television IF signal, comprising

an input for the transport channel bit-stream (TCBS),

a decoder DPCM-core (D2) for decompressing the N-C bits of a sample of the compressed transport stream (CTS) to N bits of an output sample (S2),

**characterised in that** it furthermore comprises

a phase-locked loop (PLL2) for estimating a phase ($\Phi_{dec}$) of the IF carrier based on a decoded television IF signal ($\widetilde{x}_{dec}$) from the decoder DPCM-core (D2),

a luminance estimator (LUE2) for estimating the luminance of the video signal contained in the television IF signal based on the decoded television IF signal ($\widetilde{x}_{dec}$) and on the said estimated phase ($\Phi_{dec}$) of the IF carrier, resulting in an estimated luminance ($L_{dec}$)

a shift estimator (SHE2) for estimating the amount of shift ($sh_{dec}$) based on the said estimated phase $\Phi_{dec}$ of the IF carrier and on the said estimated luminance ($L_{dec}$),

and **in that** the decoder DPCM-core (D2) comprises means to decode prediction errors which have been clipped in the encoder at the corresponding transmitting apparatus to a clip range which has been shifted there by an amount indicated by a shift estimator (SHE1).

## Patentansprüche

**1.** Verfahren zur Übertragung eines ersten Digitalsignals (DS1) von einem ersten Ort (FL) über einen Transportkanal (RC) zu einem oder zu mehreren zweiten Orten (SL), wo es als ein zweites Digitalsignal (DS2) empfangen wird, welches im Wesentlichen gleich zu dem ersten Digitalsignal (DS1) ist, womit ein Abtastwert (S1) des ersten Digitalsignals (DS1), welches durch M Bits dargestellt ist, wobei dieses die Gesamtsumme der N am meisten signifikanten Bits (MSB) und der M-N am wenigstens signifikanten Bits (LSB) ist, über den Transportkanal (TC) als ein Transportabtastwert, welcher wenigstens zwei Teile aufweist, transportiert wird, von denen

ein Teil ein komprimierter Transportabtastwert (CTS) ist, welcher durch N-C Bits dargestellt wird, wobei N kleiner als M und C kleiner als N und größer als 0 ist, wobei die N-C Bits durch prädiktives Codieren der N am meisten signifikanten Bits des Abtastwertes (S1) des ersten Digitalsignals (DS1) erhalten werden, wobei jedem Abtastwert (S1) des ersten Digitalsignals (DS1) wenigstens entspricht:

eine Prädiktion ($\hat{x}_{enc}$), basierend auf vorher komprimierten Abtastwerten und welche die vorhergesagten N am meisten signifikanten Bits des Abtastwertes (S1) des ersten Digitalsignals (DS1) darstellt,

einem Prädiktionsfehler ($e_{enc}$), welcher die Differenz zwischen den N am meisten signifikanten Bits des Abtastwertes (S1) des ersten Digitalsignals (DS1) und der Prädiktion ($\hat{x}_{enc}$) darstellt,

und einem Begrenzungsfehler, welcher die Differenz zwischen dem Prädiktionsfehler ($e_{enc}$) und einem begrenzten Prädiktionsfehler (($e_{enc}$)$_c$) darstellt, welches der Prädiktionsfehler ($e_{enc}$) ist, begrenzt durch ein erstes Begrenzungsglied (PEC1) gegenüber einem Begrenzungsbereich, welcher als [A..B] mit Hilfe von N-C Bits dargestellt wird, wobei A und B ganze Zahlen sind und B-A gleich oder kleiner als 2<(N-C)>-1 ist, und das andere Teil ein Resttransportabtastwert (RTS) ist, welcher durch M-N Bits dargestellt ist, **dadurch gekennzeichnet, dass** der Resttransportabtastwert (RTS), entweder gleich zu den M-N am wenigsten signifikanten Bits (LSB) des Abtastwertes (S1) des ersten Digitalsignals (DS1) in dem Fall ist, dass der Prädiktionsfehler ($e_{enc}$), welcher dem Abtastwert (S1) des ersten Digitalsignals (DS1) entspricht, in dem Bereich [A..B] ist oder, in dem anderen Fall, gleich zu einem Substitutionswert (CE) ist, welcher eine Funktion des Begrenzungsfehlers entsprechend dem Abtastwert (S1) des ersten Digitalsignals (DS1) ist, womit der Ausgangswert der Funktion des begrenzenden Fehlers durch M-N Bits dargestellt werden kann.

**2.** Verfahren nach Anspruch 1, **dadurch gekennzeichnet, dass** der komprimierte Transportabtastwert (CTS) der begrenzte Prädiktionsfehler (($e_{enc}$)$_c$) ist.

**3.** Verfahren nach Anspruch 1, **dadurch gekennzeichnet, dass** der komprimierte Transportabtastwert (CTS) eine in dem Bereich [A..B] herumkreisen gelassene Summe des begrenzten Prädiktionsfehlers (($e_{enc}$)$_c$) und eines digitalhierarchisch umgesetzten Wertes ($m(\hat{x}_{enc})$) der Prädiktion ($\hat{x}_{enc}$) ist, und dass der digitalhierarchisch umgesetzte Wert ($m(\hat{x}_{enc})$) der Prädiktion ($\hat{x}_{enc}$) die Prädiktion ($\hat{x}_{enc}$) ist, welche auf einen Bereich [D..E] digitalhierarchisch umgesetzt ist, wobei E und D ganze Zahlen sind und E-D gleich zu oder kleiner als $2^{(N-C)}$-1 ist.

4. Verfahren nach einem der vorausgehenden Ansprüche, **dadurch gekennzeichnet, dass** das Resttransportsignal (RTS) im PCM transportiert wird.

5. Verfahren nach einem der obigen Ansprüche, **dadurch gekennzeichnet, dass** in dem Fall, dass der Prädiktionsfehler ($e_{enc}$) entsprechend dem Abtastwert (S1) des ersten Digitalsignals (DS1) nicht in dem Bereich [A..B] ist, der Substitutionswert (CE) erhalten wird, indem zuerst der Absolutwert des begrenzenden Fehlers des Abtastwertes (S1) des ersten Digitalsignals (DS1) hergenommen wird und dann der Absolutwert auf einen Bereich begrenzt wird, welcher durch M-N Bits dargestellt werden kann.

6. Verfahren zur Übertragung eines ersten Digitalsignals (DS1) von einem ersten Ort (FL) über einen Transportkanal (TC) zu einem oder zu mehreren zweiten Orten (SL), wo es als ein zweites Digitalsignal (DS2) empfangen wird, welches im Wesentlichen gleich dem ersten Digitalsignal (DS1) ist, wobei ein Abtastwert (S1) des ersten Digitalsignals (DS1), welches durch N Bits dargestellt ist, über den Transportkanal (TC) als ein Transportabtastwert transportiert wird, welcher durch N-C Bits dargestellt ist, wobei C kleiner als N und größer als 0 ist, wobei die N-C Bits über prädiktives Codieren der N Bits des Abtastwertes (S1) des ersten Digitalsignals (DS1) erhalten werden, wobei mit jedem Abtastwert des ersten Digitalsignals (DS1) wenigstens eine Prädiktion ($\hat{x}_{enc}$) entspricht, welcher die vorhergesagten N Bits des Abastwertes (S1) des ersten Digitalsignals (DS1) darstellt, wodurch die Prädiktion auf vorher komprimierten Abtastwerten basiert, und ein Prädiktionsfehler ($e_{enc}$), welche die Differenz zwischen den N Bits des Abtastwertes (S1) des ersten Digitalsignals (DS1) und der Prädiktion ($\hat{x}_{enc}$) darstellt, **dadurch gekennzeichnet, dass** der Transportabtastwert eine in dem Bereich [A..B] herumkreisen gelassene Summe des Prädiktionsfehlers ($e_{enc}$), begrenzt auf einen Bereich, welcher als der Begrenzungsbereich [A..B] bezeichnet wird, wobei A und B ganze Zahlen sind und wobei B-A gleich zu $2^{(N-C)}$-1 ist, und einem digitalhierarchisch umgesetzten Wert ($m(\hat{x}_{enc})$) der Prädiktion ($\hat{x}_{enc}$) ist, welche auf einem Bereich [D..E] digitalhierarchisch umgesetzt ist, wobei E und D ganze Zahlen sind und wobei E-D gleich zu oder kleiner als $2^{(N-C)}$-1 ist.

7. Verfahren nach Anspruch 3 oder 6, **dadurch gekennzeichnet, dass** die Prädiktion ($\hat{x}_{enc}$) digitalhierarchisch umgesetzt ist oder in einer nicht gleichförmigen Weise quantisiert ist, so dass die Quantisierung entsprechend kleinen Eingangsamplituden für die Prädiktionswerte fein ist und für Prädiktionswerte entsprechend großen Amplituden des ersten Digitalsignals grob ist.

8. Verfahren nach einem der vorhergehenden Ansprüche, **dadurch gekennzeichnet, dass** für den Begrenzungsbereich [A..B] B-A kleiner als $2^{(N-C)}$-1 ist.

9. Verfahren nach einem der vorausgehenden Ansprüche, **dadurch gekennzeichnet, dass** der Begrenzungsbereich [A..B] für alle Abtastwerte fest ist (nicht verschiebbar ist).

10. Verfahren nach einem der Ansprüche 1 bis 8, **dadurch gekennzeichnet, dass** der Begrenzungsbereich [A..B] in jedem Abtastwert über eine Verschiebung (sh) verschiebbar ist, wobei die Verschiebung (sh) in einem Abtastwert eine Funktion eines oder mehrerer aktueller Parameter des Abtastwertes des ersten Digitalsignals ist, wobei der Begrenzungsbereich dann (A+sh..B+sh) ist.

11. Verfahren zum Übertragen eines ersten Digitalsignals (DS1) von einem ersten Ort (FL) über einen Transportkanal (TC) zu einem oder zu mehreren zweiten Orten (SL), wo es als ein zweites Digitalsignal (SL) empfangen wird, welches im Wesentlichen gleich dem ersten Digitalsignal (DS1) ist, womit ein Abtastwert (S1) des ersten Digitalsignals (DS1), welcher durch N Bits dargestellt ist, über den Transportkanal (TC) als ein Transportabtastwert transportiert wird, welcher durch N-C Bits dargestellt ist, wobei C kleiner als N und größer als 0 ist, wobei N-C Bits über prädiktives Codieren der N Bits des Abtastwertes (S1) des ersten Digitalsignals (DS1) erhalten werden, wodurch jedem Abtastwert (S1) des ersten Digitalsignals (DS1) wenigstens eine Prädiktion ($\hat{x}_{enc}$) entspricht, welche die vorhergesagten N Bits des Abtastwertes (S1) des ersten Digitalsignals (DS1) darstellt, wodurch die Prädiktion ($\hat{x}_{enc}$) auf vorher komprimierten Abtastwerten basiert und ein Prädiktionsfehler ($e_{enc}$), welcher die Differenz zwischen N Bits des Abtastwertes (S1) des ersten Digitalsignals (DS1) und der Prädiktion ($\hat{x}_{enc}$) darstellt, und wodurch der Transportabtastwert der Prädiktionsfehler ($e_{enc}$) ist, welcher auf einen Bereich begrenzt ist, welcher als Begrenzungsbereich bezeichnet wird, welcher mit Hilfe von N-C Bits dargestellt werden kann, **dadurch gekennzeichnet, dass** der Begrenzungsbereich in Funktion eines oder mehrerer aktueller Parameter des ersten Digitalsignals verschiebbar ist.

**12.** Verfahren nach einem der vorausgehenden Ansprüche, wodurch das erste Digitalsignal (DS1) ein digitalisiertes Fernseh-IF-Signal ist, wobei das zweite Digitalsignal (DS2) folglich auch ein digitalisiertes Fernseh-IF-Signal ist.

**13.** Verfahren nach einem der Ansprüche 1 bis 8 oder 10 bis 11, wodurch das erste Digitalsignal (DS1) ein digitalisiertes Fernseh-IF-Signal mit einem IF-Träger ist und wobei es als Parameter wenigstens eine abgeschätzte Helligkeit und eine abgeschätzte IF-Trägerphase als Merkmale enthält, wobei das zweite Digitalsignal (Ds2) folglich auch ein digitalisiertes Fernseh-IF-Signal ist, **dadurch gekennzeichnet, dass**

- der Begrenzungsbereich [A..B] über eine Verschiebung (sh) auf [A+sh..B+sh] verschoben wird, wobei die Verschiebung (sh) für einen Abtastwert durch die abgeschätzte Helligkeit und/oder durch die abgeschätzte IF-Trägerphase in dem Abtastwert bestimmt wird,
- der Absolutbetrag der Verschiebung (sh) proportional zu dem Absolutwert der Amplitude des abgeschätzten IF-Trägers ist,
- für ein Fernseh-IF-Signal mit negativer Modulation, entweder die Verschiebung (sh) im Falle eines positiven Spitzenwerts des abgeschätzten IF-Trägers und einer niedrigen Helligkeit negativ ist und im Falle eines negativen Spitzenwertes des abgeschätzten IF-Trägers und einer hohen Helligkeit, oder die Verschiebung positiv ist, im Falle eines negativen Spitzenwerts des abgeschätzten IF-Trägers und einer niedrigen Helligkeit, und im Falle eines positiven Spitzenwerts des abgeschätzten IF-Trägers und einer hohen Helligkeit,
- für ein Fernseh-IF-Signal mit positiver Modulation, entweder die Verschiebung (sh) positiv ist im Falle eines positiven Spitzenwerts des abgeschätzten IF-Trägers und einer niedrigen Helligkeit, und im Falle eines negativen Spitzenwerts des abgeschätzten IF-Trägers und einer hohen Helligkeit, oder die Verschiebung (sh) negativ ist, im Falle eines negativen Spitzenwertes des abgeschätzten IF-Trägers und einer niedrigen Helligkeit, und im Falle eines positiven Spitzenwertes des abgeschätzten IF-Trägers und einer hohen Helligkeit.

**14.** Verfahren nach Anspruch 13, wodurch es an dem ersten Ort ein Codierglied für prädiktives Codieren eines Teils oder aller Bits eines Abtastwertes gibt und wodurch es bei jedem zweiten Ort (SL) ein Decodierglied für das Decodieren der vorhergesagt codierten Bits eines Abtastwertes gibt und wodurch das Codierglied ein lokales Decodierglied enthält, um die übertragenen, vorhergesagt codierten Bits eines Abtastwertes lokal zu decodieren, **dadurch gekennzeichnet, dass**, um die Helligkeit in dem ersten und in dem zweiten Ort abzuschätzen, der IF-Träger sowohl am ersten als auch am zweiten Ort zuerst abgeschätzt wird und dann an dem ersten Ort (FL) mit dem Ausgangssignal eines lokalen Decodiergliedes und an dem zweiten Ort (SL) mit dem Ausgangssignal eines Decodiergliedes multipliziert wird und schließlich sowohl an dem ersten als auch an dem zweiten Ort tiefpassgefiltert wird.

**15.** Verfahren nach einem der Ansprüche 13 oder 14, **dadurch gekennzeichnet, dass**, um den IF-Träger in dem ersten und dem zweiten Ort abzuschätzen, das Ausgangssignal eines lokalen Decodiergliedes an dem ersten Ort oder das Ausgangssignal des Decodiergliedes an dem zweiten Orten zuerst bandpassgefiltert wird und dann an beiden Orten das Ausgangssignal des Bandpassfilters das Eingangssignal eines Phasenregelkreises ist, welcher die Phase des IF-Trägers mitführt.

**16.** Übertragungsgerät bzw. Sendegerät zum Umformen eines digitalisierten Fernseh-IF-Signals in einen Transportkanalbitstrom (TCBS) zum Übertragen des digitalisierten Fernseh-IF-Signals von einem ersten Ort (FL) zu einem oder zu mehreren zweiten Orten (SL), welches aufweist:

ein Verzweigungsglied (SP) zum Aufteilen eines Abtastwertes (S1) des digitalisierten Fernseh-IF-Signals in N am meisten signifikante Bits (MSB) und in M-N am wenigsten signifikante Bits (LSB), einen Codierglied-DPCM-Kern (D1) zum Komprimieren der N am meisten signifikanten Bits (MSB) eines Abtastwertes (S1) in einen N-C-Bit-komprimierten Transportabtastwert (CTS), welcher einen begrenzten Prädiktionsfehler $((e_{enc})_c)$ erzeugt, und einen Ausgang für den Transportkanalbitstrom (TCBS),

**dadurch gekennzeichnet, dass** es ferner aufweist:

einen begrenzenden Detektor am ersten Ort (BSC1) zum Erzeugen eines PCM-Bits-Substitutionssteuersignals (SC1) am ersten Ort, welches anzeigt, was als Resttransportabtastwert (RTS) zu senden ist, entweder die M-N am wenigsten signifikanten Bits (LSB) des Abtastwertes (S1) des ersten digitalisierten Fernseh-IF-Signals oder eines Substitutionswertes (CE), welcher eine erste Funktion des begrenzenden Fehlers entsprechend dem Abtastwert (S1) des ersten digitalisierten Fernseh-IF-Signals ist, und ein Substitutionsglied am ersten Ort (BS1) zum Substituieren der M-N am wenigsten signifikanten Bits (LSB) durch einen Substitutionswert (CE), abhängig von dem Wert des PCM-Bits-Substitutionssteuersignal (SC1) am ersten Ort.

**17.** Sendegerät nach Anspruch 16, **dadurch gekennzeichnet, dass** es auch aufweist:

- ein Prädiktions-Digitalhierarchie-Umsetzglied (PM1) zum Erzeugen einer digitalisierten umgesetzten Prädiktion ($m(\hat{x}_{enc})$) von einer Codierglied-Prädiktion ($\hat{x}_{enc}$) von dem Codierglied-DPCM-Kern (D1), und
- ein Addierglied (ADD12), welches die Digitalhierarchie-umgesetzte Prädiktion ($m(\hat{x}_{enc})$) und den begrenzten Prädiktionsfehler ($(e_{enc})_c$) addiert und dann das Ergebnis der Addition herumkreisen lässt, so dass **dadurch** ein komprimierter Transportabtastwert (CTS) erhalten wird,

und **dadurch**, dass:

- der Codierglied-DPCM-Kern (D1) eine Einrichtung aufweist, um die Prädiktionsfehler auf einen Bereich kleiner als $2^{(N-C)}-1$ zu begrenzen, und/oder
- das Prädiktions-Digitalhierarchie-Umsetzglied (PM1) eine Vorrichtung für ein nicht gleichförmiges Digitalhierarchie-Umsetzen aufweist.

**18.** Sendegerät zum Umformen eines digitalisierten Fernseh-IF-Signals in einen Transportkanalbitstrom (TCBS) zum Senden des digitalisierten Fernseh-IF-Signals von einem ersten Ort (FL) zu einem oder zu mehreren zweiten Orten (SL), welches aufweist:

einen Codierglied-DPCM-Kern (D1) zum Komprimieren eines Abtastwertes (S1) des ersten digitalisierten Fernseh-IF-Signals, dargestellt durch N Bits, in einen N-C-Bit-komprimierten Transportabtastwert (CTS), wobei eine Prädiktion ($\hat{x}_{enc}$) und ein begrenzter Prädiktionsfehler ($(e_{enc})_c$) erzeugt werden, und einen Ausgang für den Transportkanalbitstrom (TCBS),

**dadurch gekennzeichnet, dass** es ferner aufweist:

einen Prädiktions-Digitalhierarchie-Umsetzer (PM1) zum Erzeugen einer digitalhierarchisch umgesetzten Prädiktion ($m(\hat{x}_{enc})$) von der Prädiktion ($\hat{x}_{enc}$) von dem Codierglied-DPCM-Kern (D1), und ein Addierglied (ADD12) zum Addieren der digitalhierarchisch umgesetzten Prädiktion ($m(\hat{x}_{enc})$) und des begrenzten Prädiktionsfehlers ($(e_{enc})_c$) und dann zum Herumkreisenlassen des Ergebnisses der Addition, wobei **dadurch** ein komprimierter Transportabtastwert (CTS) erhalten wird,

und **dadurch**, dass:

der Codierglied-DPCM-Kern (D1) eine Vorrichtung aufweist, um die Prädiktionsfehler auf einen Bereich kleiner als $2^{(N-C)}-1$ zu begrenzen, und/oder das Prädiktions-digitalhierarchische Umsetzglied (PM1) eine Vorrichtung aufweist, um ein nicht gleichförmiges digitalhierarchisches Umsetzen durchzuführen.

**19.** Sendegerät nach einem der Ansprüche 16, 17 oder 18, **dadurch gekennzeichnet, dass** es auch aufweist:

- einen Phasenregelkreis (PLL1), welcher die Phase ($\Phi_{enc}$) des IF-Trägers des digitalisierten Fernseh-IF-Signals basierend auf einem lokal decodierten Fernseh-IF-Signal ($\tilde{x}_{enc}$) von dem Codierglied-DPCM-Kern (D1) abschätzt,
- ein Helligkeitsabschätzglied (LUE1), welches die Helligkeit des Video-Signals, welches in dem digitalisierten Fernseh-IF-Signal enthalten ist, basierend auf dem decodierten Fernseh-IF-Signal ($\tilde{x}_{enc}$) und auf der geschätzten Phase ($\Phi_{enc}$) des IF-Trägers abschätzt, was zu einer abgeschätzten Helligkeit ($L_{enc}$) führt, und
- ein Verschiebungsabschätzglied (SHE1), welches eine Verschiebung ($sh_{enc}$) basierend auf der abgeschätzten Phase ($\Phi_{enc}$) des IF-Trägers und auf der abgeschätzten Helligkeit ($L_{enc}$) abschätzt,

und **dadurch**, dass der Codierglied-DPCM-Kern eine Vorrichtung aufweist, um den Prädiktionsfehler ($e_{enc}$) auf einen Bereich zu begrenzen, welcher über eine Verschiebung ($sh_{enc}$) verschoben ist.

**20.** Sendegerät zum Umsetzen eines digitalisierten Fernseh-IF-Signals in einen Transportkanalbitstrom (TCBS) zum Übertragen des digitalisierten Fernseh-IF-Signals von einem ersten Ort (FL) zu einem oder zu mehreren zweiten Orten (SL), welches aufweist:

einen Codierglied-DPCM-Kern (D1) zum Komprimieren eines Abtastwertes (S1) des ersten digitalisierten Fernseh-IF-Signals, welches durch N Bits dargestellt wird, in einen N-C-Bit-komprimierten Transportabtastwert (CTS), welcher eine Prädiktion ($\hat{x}_{enc}$) und einen begrenzten Prädiktionsfehler (($e_{enc})_c$) erzeugt, und einen Ausgang für den Transportkanalbitstrom (TCBS),

**dadurch gekennzeichnet, dass** es ferner aufweist:

eine Phasenregelschleife (PLL1) zum Abschätzen der Phase ($\Phi_{enc}$) des IF-Trägers des digitalisierten Fernseh-IF-Signals, basierend auf einem lokal decodierten Fernseh-IF-Signal ($\tilde{x}_{enc}$) von dem Codierglied-DPCM-Kern (D1), ein Helligkeitsabschätzglied (LUE1) zum Abschätzen der Helligkeit des Video-Signals, welches in dem digitalisierten Fernseh-IF-Signal enthalten ist, basierend auf dem decodierten Fernseh-IF-Signal ($\tilde{x}_{enc}$) und auf der abgeschätzten Phase ($\Phi_{enc}$) des IF-Trägers, wobei eine abgeschätzte Helligkeit ($L_{enc}$) erhalten wird, und ein Verschiebeabschätzglied (SHE1) zum Abschätzen einer Verschiebung ($sh_{enc}$) basierend auf der abgeschätzten Phase ($\Phi_{enc}$) des IF-Trägers auf der abgeschätzten Helligkeit ($L_{enc}$),

und **dadurch**, dass der Codierglied-DPCM-Kern eine Vorrichtung aufweist, um den Prädiktionsfehler ($e_{enc}$) auf einen Bereich zu begrenzen, welcher über eine Verschiebung ($sh_{enc}$) verschoben ist.

**21.** Empfangsgerät zum Umformen eines Transportkanalbitstroms (TCBS), welcher ein erstes digitalisiertes Fernseh-IF-Signal enthält, welches durch Transportabtastwerte dargestellt ist, welche auf wenigstens einem N-C-Bitskomprimierten Transportabtastwert (CTS) und einem M-N-Bits-Resttransportabtastwert (RTS) aufgebaut sind, und welcher mit einem Gerät nach Anspruch 16, 17 oder 19 übertragen wird, in ein zweites digitalisiertes Fernseh-IF-Signal, welches aufweist:

einen Eingang für den Transportkanalbitstrom (TCBS), einen Decodierglied-DPCM-Kern (D2) zum Dekomprimieren der N-C Bits eines komprimierten Transportabtastwertes (CTS) auf N MSBs eines Ausgangsabtastwertes (S2), und ein Kombinierglied (CB),

**dadurch gekennzeichnet, dass** es außerdem aufweist:

einen begrenzenden Detektor (BSC2) am zweiten Ort zum Erzeugen eines PCM-Bits-Substitutionssteuersignals (SC2) am zweiten Ort, welches anzeigt, was als M-N am wenigsten signifikante Bits des Ausgangsabtastwertes (S2) auszuwählen ist, und ein Vorzeichensignal (SGN), welches das Vorzeichenbit des übertragenen, transformierten, begrenzenden Fehlers ist, ein Substitutionsglied (BS2) am zweiten Ort zum Schalten bzw. Vermitteln zwischen den empfangenen M-N LSBs von dem Resttransportabtastwert (RTS) und einem festen Ersetzen entsprechend dem PCM-Bits-Substitutionssteuersignal (SC2) am zweiten Ort, und ein MSB-Korrekturglied (COR) zum Addieren oder Subtrahieren zu oder von dem Ausgangssignal des Decodierglied-DPCM-Kerns (D2) den Ausgangswert des Digitalhierarchie-Umsetzens des empfangenen Transportabtastwertes (RTS) mit Hilfe einer zweiten Funktion entsprechend dem PCM-Bits-Substitutionssteuersignal (SC2) am zweiten Ort und dem Vorzeichensignal (SGN), wodurch das Kombinierglied eine Vorrichtung zum Kombinieren der N MSBs eines Abtastwertes mit dem M-N-Bits-Resttransportabtastwert oder mit dem festgelegten Ersetzen in einen Ausgangsabtastwert (S2) besitzt.

**22.** Empfangsgerät nach Anspruch 21, **dadurch gekennzeichnet, dass** es auch aufweist:

- ein Prädiktions-Digitalhierarchie-Umsetzglied (PM2) zum Erzeugen einer Digitalhierarchie-umgesetzten Prädiktion ($m(\hat{x}_{dec})$) von einer Decodierglied-Prädiktion ($\hat{x}_{dec}$) von dem Decodierglied-DPCM-Kern (D2), wobei das Prädiktions-Digitalhierarchie-Umsetzglied (PM2) eine Vorrichtung für ein nicht gleichförmiges Digitalhierarchie-Umsetzen aufweist, und
- ein Subtrahierglied (SUB21), welches die Digitalhierarchie-umgesetzte Prädiktion ($m(\hat{x}_{dec})$) von dem Abtastwert des komprimierten Transportstroms (CTS) subtrahiert und welches dann ein Herumkreisenlassen des Ergebnisses der Subtraktion durchführen lässt, wobei so ein begrenzter Prädiktionsfehler (($e_{dec})_c$) erhalten wird.

**23.** Empfangsgerät zum Umformen eines Transportkanalbitstroms (TCBS), welcher ein erstes digitalisiertes Fernseh-IF-Signal enthält, welches durch Transportabtastwerte dargestellt ist, welche aus wenigstens einem N-C-Bitskomprimierten Transportabtastwert (CTS) aufgebaut ist, und welches mit einem Gerät entsprechend Anspruch 18 oder 19 in ein zweites digitalisiertes Fernseh-IF-Signal übertragen wird, welches aufweist:

einen Eingang für den Transportkanalbitstrom (TCBS),
einen Decodierglied-DPCM-Kern (D2),

**dadurch gekennzeichnet, dass** es ferner aufweist:

ein Prädiktions-Digitalhierarchie-Umsetzglied (PM2) zum Erzeugen einer Digitalhierarchie-umgesetzten Prädiktion $(m(\hat{x}_{dec}))$ von einer Decodierglied-Prädiktion $(\hat{x}_{dec})$ von dem Decodierglied-DPCM-Kern (D2), womit das Prädiktions-Digitalisierhierarchie-Umsetzglied (PM2) eine Vorrichtung für ein nicht gleichförmiges Digitalhierarchie-Umsetzen aufweist, und
ein Subtraktionsglied (SUB21) zum Subtrahieren der Digitalhierarchie-umgesetzten Prädiktion $(m(\hat{x}_{dec}))$ von dem Abtastwert des komprimierten Transportstromes (CTS) und zum Herumkreisenlassen des Ergebnisses der Subtraktion, wobei somit ein begrenzter Prädiktionsfehler $((e_{dec})_c)$ erhalten wird,
womit der Decodierglied-DPCM-Kern (D2) eine Vorrichtung zum Dekomprimieren der N-C-Bits des begrenzten Prädiktionsfehlers $((e_{dec})_c)$ auf N Bits eines Ausgangsabtastwertes (S2) besitzt.

**24.** Empfangsgerät nach einem der Ansprüche 21, 22 oder 23, **dadurch gekennzeichnet, dass** es auch aufweist:

- einen Phasenregelkreis (PLL2), welcher eine Phase $(\Phi_{dec})$ des IF-Trägers basierend auf einem decodierten Fernseh-IF-Signal $(\tilde{x}_{dec})$ von dem Decodierglied-DPCM-Kern (D2) abschätzt,
- ein Helligkeitsabschätzglied (LUE2), welches die Helligkeit des Video-Signals, welches in dem Fernseh-IF-Signal enthalten ist, basierend auf dem decodierten Fernseh-IF-Signal $(\tilde{x}_{dec})$ und auf der abgeschätzten Phase $(\Phi_{dec})$ des IF-Trägers abschätzt, was zu einer abgeschätzten Helligkeit $(L_{dec})$ führt, ein Verschiebungsabschätzglied (SHE2), welches den Betrag der Verschiebung $(sh_{dec})$ basierend auf der abgeschätzten Phase $(\Phi_{dec})$ des IF-Trägers und auf der abgeschätzten Helligkeit $(L_{dec})$ abschätzt,
und **dadurch**, dass der Decodierglied-DPCM-Kern (D2) eine Vorrichtung aufweist, um die Prädiktionsfehler zu decodieren, welche in dem Codierglied bei dem entsprechenden Sendegerät auf einen Begrenzungsbereich begrenzt wurden, welcher dorthin um eine Betrag verschoben wurde, welcher durch ein Verschiebungsabschätzglied (SHE1) angezeigt ist.

**25.** Empfangsgerät zum Umformen eines Transportkanalbitstroms (TCBS), welcher ein erstes digitalisiertes Fernseh-IF-Signal enthält, welches durch Transportabtastwerte dargestellt ist, welche aus wenigstens einem N-C-Bitskomprimierten Transportabtastwert (CTS) aufgebaut ist, und welches über ein Gerät nach Anspruch 20, in ein zweites digitalisiertes Fernseh-IF-Signal übertragen wird, durch ein Verfahren entsprechend dem Verfahren des Komprimierens des ersten digitalisierten Fernseh-IF-Signals, welches aufweist:

einen Eingang für den Transportkanalbitstrom (TCBS),
einen Decodierglied-DPCM-Kern (D2) für das Dekomprimieren der N-C-Bits eines Abtastwertes des komprimierten Transportstromes (CTS) auf N Bits eines Ausgangsabtastwertes (S2),

**dadurch gekennzeichnet, dass** es ferner aufweist:

einen Phasenregelkreis (PLL2) zum Abschätzen einer Phase $(\Phi_{dec})$ des IF-Trägers basierend auf einem decodierten Fernseh-IF-Signal $(\tilde{x}_{dec})$ von dem Decodierglied-DPCM-Kern (D2),
ein Helligkeitsabschätzglied (LUE2) zum Abschätzen der Helligkeit des Video-Signals, welches in dem Fernseh-IF-Signal enthalten ist, basierend auf dem decodierten Fernseh-IF-Signal $(\tilde{x}_{dec})$ und auf der abgeschätzten Phase $(\Phi_{dec})$ des IF-Trägers, was zu einer abgeschätzten Helligkeit $(L_{dec})$ führt,
ein Verschiebungsabschätzglied (SHE2) zum Abschätzen des Betrages der Verschiebung $(sh_{dec})$ basierend auf der abgeschätzten Phase $(\Phi_{dec})$ des IF-Trägers und auf der abgeschätzten Helligkeit $(L_{dec})$,

und **dadurch**, dass der Decodierglied-DPCM-Kern (D2) eine Vorrichtung aufweist, um die Prädiktionsfehler zu decodieren, welche in dem Codierglied bei dem entsprechenden Sendegerät auf einen Begrenzungsbereich begrenzt wurden, welcher durch einen Betrag, der durch ein Verschiebungsabschätzglied (SHE1) dorthin verschoben wurde, angezeigt ist.

**Revendications**

1. Procédé pour la transmission d'un premier signal numérique (DS1) en provenance d'un premier emplacement (FL) sur un canal de transport (TC) vers un ou plusieurs seconds emplacements (SL) où il est reçu en tant que second signal numérique (DS2) qui est sensiblement égal au premier signal numérique (DS1), de sorte qu'un échantillon (S1) du premier signal numérique (DS1) représenté par M bits, étant le total des N bits les plus significatifs (MSB) et des M - N bits les moins significatifs (LSB), est transporté sur le canal de transport (TC) en tant qu'échantillon de transport comprenant au moins deux parties, dont :

   - une partie est un échantillon comprimé de transport (CTS) représenté par N - C bits, N étant inférieur à M et C étant inférieur à N et supérieur à 0, les N - C bits étant obtenus par un codage prédictif des N bits les plus significatifs de l'échantillon (S1) du premier signal numérique (DS1), de sorte qu'à chaque échantillon (S1) du premier signal numérique (DS1) correspond au moins :

   une prédiction $(\hat{x}_{enc})$, basée sur des échantillons précédemment comprimés et représentant les N bits les plus significatifs prédits de l'échantillon (S1) du premier signal numérique (DS1),
   une erreur de prédiction $(e_{enc})$ représentant la différence entre les N bits les plus significatifs de l'échantillon (S1) du premier signal numérique (DS1) et ladite prédiction $(\hat{x}_{enc})$,
   et une erreur d'écrêtage représentant la différence entre l'erreur de prédiction $(e_{enc})$ et une erreur de prédiction écrêtée $(e_{enc})_c$ qui est l'erreur de prédiction $(e_{enc})$ écrêtée par un premier dispositif d'écrêtage (PEC1) à une plage d'écrêtage représentée par [A .. B] au moyen de N - C bits, A et B étant des entiers et B - A étant inférieur ou égal à $2^{(N-C)} - 1$, et

   - l'autre partie est un échantillon résiduel de transport (RTS) représenté par M - N bits, **caractérisée en ce que** ledit échantillon résiduel de transport (RTS) est soit égal aux M - N bits les moins significatifs (LSB) dudit échantillon (S1) du premier signal numérique (DS1) dans le cas où l'erreur de prédiction $(e_{enc})$ correspondant audit échantillon (S1) du premier signal numérique (DS1) est dans la plage [A .. B], soit, dans l'autre cas, il est égal à une valeur de substitution (CE) qui est une fonction de l'erreur d'écrêtage correspondant audit échantillon (S1) du premier signal numérique (DS1), de sorte que la valeur de sortie de ladite fonction de l'erreur d'écrêtage peut être représentée par M - N bits.

2. Procédé selon la revendication 1, **caractérisé en ce que** l'échantillon comprimé de transport (CTS) est l'erreur de prédiction écrêtée $((e_{enc})_c)$.

3. Procédé selon la revendication 1, **caractérisé en ce que** l'échantillon comprimé de transport (CTS) est, dans la plage [A .. B], une somme reportée de l'erreur de prédiction écrêtée $((e_{enc})_c)$ et d'une valeur mise en correspondance $(m (\hat{x}_{enc}))$ de la prédiction $(\hat{x}_{enc})$, et **en ce que** ladite valeur mise en correspondance $(m (\hat{x}_{enc}))$ de la prédiction $(\hat{x}_{enc})$ est la prédiction $(\hat{x}_{enc})$ mise en correspondance sur une plage [D .. E], E et D étant des entiers et E - D étant inférieur ou égal à $2^{(N-C)} - 1$.

4. Procédé selon l'une quelconque des revendications précédentes, **caractérisé en ce que** le signal résiduel de transport (RTS) est transporté en PCM.

5. Procédé selon l'une quelconque des revendications précédentes, **caractérisé en ce que**, dans le cas où l'erreur de prédiction $(e_{enc})$ correspondant audit échantillon (S1) du premier signal numérique (DS1) n'est pas dans la plage [A .. B], ladite valeur de substitution (CE) est obtenue en prenant d'abord la valeur absolue de l'erreur d'écrêtage dudit échantillon (S1) du premier signal numérique (DS1), et en écrêtant ensuite ladite valeur absolue à une plage qui peut être représentée par M - N bits.

6. Procédé pour la transmission d'un premier signal numérique (DS1) en provenance d'un premier emplacement (FL) sur un canal de transport (TC) vers un ou plusieurs seconds emplacements (SL) où il est reçu en tant que second signal numérique (DS2) qui est sensiblement égal au premier signal numérique (DS1), de sorte qu'un échantillon (S1) du premier signal numérique (DS1) représenté par N bits, est transporté sur le canal de transport (TC) comme un échantillon de transport représenté par N - C bits, C étant inférieur à N et supérieur à 0, les N - C bits étant obtenus par un codage prédictif des N bits de l'échantillon (S1) du premier signal numérique (DS1), de sorte qu'à chaque échantillon du premier signal numérique (DS1) correspond au moins une prédiction $(\hat{x}_{enc})$ représentant les N bits prédits de l'échantillon (S1) du premier signal numérique (DS1), de sorte que la prédiction est basée sur des échantillons précédemment comprimés, et une erreur de prédiction $(e_{enc})$ représentant la différence entre les N bits de l'échantillon (S1) du premier signal numérique (DS1) et ladite prédiction ($\hat{x}_{enc}$), **caractérisé en ce que** l'échantillon de transport est, dans la plage [A .. B], une somme reportée de l'erreur de prédiction *($e_{enc}$)* écrêtée à une plage nommée plage d'écrêtage [A .. B], A et B étant des entiers et B - A étant égal à $2^{(N-C)}$ - 1, et d'une valeur mise en correspondance (m ($\hat{x}_{enc}$)) de la prédiction ($\hat{x}_{enc}$) qui a été mise en correspondance sur une plage [D .. E], E et D étant des entiers et E - D étant inférieur ou égal à $2^{(N-C)}$ - 1.

7. Procédé selon la revendication 3 ou 6, **caractérisé en ce que** la prédiction ($\hat{x}_{enc}$) *es*t mise en correspondance ou quantifiée d'une façon non uniforme, de sorte que la quantification est fine pour des valeurs de prédiction correspondant à de petites amplitudes d'entrée et grossière pour des valeurs de prédiction correspondant à de grandes amplitudes du premier signal numérique.

8. Procédé selon l'une quelconque des revendications précédentes, **caractérisé en ce que** pour la plage d'écrêtage [A .. B], B - A est inférieur à $2^{(N-C)}$ - 1.

9. Procédé selon l'une quelconque des revendications précédentes, **caractérisé en ce que** la plage d'écrêtage [A .. B] est fixe (ne pouvant pas être décalée) pour tous les échantillons.

10. Procédé selon l'une quelconque des revendications 1 à 8, **caractérisé en ce que** la plage d'écrêtage [A .. B] peut être décalée dans chaque échantillon d'un décalage *(sh),* le décalage *(sh)* dans un échantillon étant une fonction d'un ou de plusieurs paramètres actuels dudit échantillon du premier signal numérique, la plage d'écrêtage étant alors [A + *sh* .. B + *sh*].

11. Procédé pour la transmission d'un premier signal numérique (DS1) en provenance d'un premier emplacement (FL) sur un canal de transport (TC) vers un ou plusieurs seconds emplacements (SL) où il est reçu en tant que second signal numérique (SL) qui est sensiblement égal au premier signal numérique (DS1), de sorte qu'un échantillon (S1) du premier signal numérique (DS1), représenté par N bits, est transporté sur le canal de transport (TC) comme un échantillon de transport représenté par N - C bits, C étant inférieur à N et supérieur à 0, les N - C bits étant obtenus par un codage prédictif des N bits de l'échantillon (S1) du premier signal numérique (DS1), de sorte qu'à chaque échantillon (S1) du premier signal numérique (DS1) correspond au moins une prédiction ($\hat{x}_{enc}$) représentant les N bits prédits de l'échantillon (S1) du premier signal numérique (DS1), de sorte que la prédiction ($\hat{x}_{enc}$) est basée sur des échantillons précédemment comprimés, et une erreur de prédiction ($e_{enc}$) représentant la différence entre les N bits de l'échantillon (S1) du premier signal numérique (DS1) et ladite prédiction ($\hat{x}_{enc}$), et de sorte que l'échantillon de transport est l'erreur de prédiction *($e_{enc}$)* écrêtée à une plage nommée plage d'écrêtage, qui peut être représentée au moyen des N - C bits, **caractérisé en ce que** la plage d'écrêtage peut être décalée en fonction d'un ou plusieurs paramètres actuels du premier signal numérique.

12. Procédé selon l'une des revendications précédentes, de sorte que le premier signal numérique (DS1) est un signal FI de télévision numérique, le second signal numérique (DS2) étant par conséquent également un signal FI de télévision numérique.

13. Procédé selon l'une quelconque des revendications 1 à 8 ou 10 à 11, de sorte que le premier signal numérique (DS1) est un signal FI de télévision numérique avec une porteuse FI et particularisant comme paramètres au moins une luminance évaluée et une phase porteuse FI évaluée, le second signal numérique (DS2) étant par conséquent également un signal FI de télévision numérique, **caractérisé en ce que**

- la plage d'écrêtage [A .. B] est décalée sur un décalage *(sh)* à [A + *sh* .. B + *sh*], de sorte que le décalage *(sh)* pour un échantillon est déterminé par la luminance évaluée et/ou par la phase porteuse FI évaluée dans cet échantillon,
- la quantité absolue du décalage *(sh)* est proportionnelle à la valeur absolue de l'amplitude de la porteuse FI évaluée,
- pour un signal FI de télévision ayant une modulation négative, soit le décalage est négatif *(sh)* en cas d'un pic positif de la porteuse FI évaluée et d'une faible luminance, et en cas d'un pic négatif de la porteuse FI évaluée et d'une forte luminance, soit le décalage *(sh)* est positif en cas d'un pic négatif de la porteuse FI évaluée et d'une faible luminance, et en cas d'un pic positif de la porteuse FI évaluée et d'une forte luminance,
- pour un signal FI de télévision ayant une modulation positive, soit le décalage *(sh)* est positif en cas d'un pic positif de la porteuse FI évaluée et d'une faible luminance, et en cas d'un pic négatif de la porteuse FI évaluée et d'une forte luminance, soit le décalage (sh) est négatif en cas d'un pic négatif de la porteuse FI évaluée et d'une faible luminance, et en cas d'un pic positif de la porteuse FI évaluée et d'une forte luminance.

**14.** Procédé selon la revendication 13, de sorte qu'au premier emplacement, il y a un codeur pour le codage prédictif d'une partie ou de la totalité des bits d'un échantillon, et de sorte qu'au niveau de chaque second emplacement (SL), il y a un décodeur pour décoder les bits codés de manière prédictive d'un échantillon, et de sorte que le codeur contient un décodeur local pour localement décoder les bits codés de manière prédictive transmis d'un échantillon, **caractérisé en ce que** pour évaluer la luminance dans le premier et dans les seconds emplacements, la porteuse FI est d'abord évaluée tant au niveau du premier que des seconds emplacements, et est ensuite multipliée au niveau du premier emplacement (FL) par la sortie d'un décodeur local et au niveau du second emplacement (SL) par la sortie d'un décodeur, et est finalement soumise à un filtrage passe-bas tant au niveau du premier que des seconds emplacements.

**15.** Procédé selon l'une quelconque des revendications 13 ou 14, **caractérisé en ce que** pour évaluer la porteuse FI dans le premier et les seconds emplacements, la sortie d'un décodeur local au niveau du premier emplacement ou la sortie du décodeur au niveau des seconds emplacements subit d'abord un filtrage passe-bande et ensuite au niveau des deux emplacements, la sortie du filtre passe-bande est l'entrée d'une boucle à phase asservie qui suit la phase de la porteuse FI.

**16.** Appareil d'émission pour transformer un signal FI de télévision numérique en un flot binaire de canal de transport (TCBS) pour la transmission dudit signal FI de télévision numérique en provenance d'un premier emplacement (FL) vers un ou plusieurs seconds emplacements (SL) comprenant :

un séparateur (SP) pour partager un échantillon (S1) dudit signal FI de télévision numérique en N bits les plus significatifs (MSB) et en M - N bits les moins significatifs (LSB),
un coeur DPCM de codeur (D1) pour la compression des N bits les plus significatifs (MSB) d'un échantillon (S1) en un échantillon comprimé de transport (CTS) de N - C bits, produisant une erreur de prédiction écrêtée $(e_{enc})_c$, et
une sortie pour le flot binaire de canal de transport (TCBS), **caractérisé en ce qu'**il comprend en outre :

un détecteur d'écrêtage de premier emplacement (BSC1) pour produire un signal de commande de substitution de bits PCM de premier emplacement (SC1) indiquant ce qui doit être transmis en tant qu'échantillon résiduel de transport (RTS), soit les M - N bits les moins significatifs (LSB) de l'échantillon S1 du premier signal FI de télévision numérique, soit une valeur de substitution (CE) qui est une première fonction de l'erreur d'écrêtage correspondant audit échantillon S1 du premier signal FI de télévision numérique, et
un dispositif de substitution de premier emplacement (BS1) pour substituer les M - N bits les moins significatifs (LSB) par une valeur de substitution (CE), en fonction de la valeur du signal de commande de substitution de bits PCM de premier emplacement (SC1).

**17.** Appareil d'émission selon la revendication 16, **caractérisé en ce qu'**il comprend également :

- un dispositif de mise en correspondance de prédiction (PM1) pour produire une prédiction mise en correspondance $(m(\hat{x}_{enc}))$ à partir d'une prédiction de codeur $(\hat{x}_{enc})$ en provenance du coeur DPCM de codeur (D1), et
- un additionneur (ADD12) qui additionne la prédiction mise en correspondance $(m(\hat{x}_{enc}))$ et l'erreur de prédiction écrêtée $((e_{enc})_c)$, et reporte ensuite le résultat de l'addition, obtenant ainsi un échantillon comprimé de transport (CTS), et **en ce que**
- le coeur DPCM de codeur (D1) comprend un moyen pour écrêter les erreurs de prédiction à une plage inférieure à $2^{(N-C)} - 1$, et/ou
- le dispositif de mise en correspondance de prédiction (PM1) comprend un moyen pour une mise en correspondance non uniforme.

**18.** Appareil d'émission pour transformer un signal FI de télévision numérique en un flot binaire de canal de transport (TCBS) pour la transmission dudit signal FI de télévision numérique en provenance d'un premier emplacement (FL) vers un ou plusieurs seconds emplacements (SL) comprenant :

un coeur DPCM de codeur (D1) pour la compression d'un échantillon S1 du premier signal FI de télévision numérique, représenté par N bits, en un échantillon comprimé de transport (CTS) de N - C bits, produisant une prédiction $(\hat{x}_{enc})$ et une erreur de prédiction écrêtée $(e_{enc})_c$, et
une sortie pour le flot binaire de canal de transport (TCBS),

**caractérisé en ce qu'**il comprend en outre :

un dispositif de mise en correspondance de prédiction (PM1) pour produire une prédiction mise en correspondance m ($\hat{x}_{enc}$) de la prédiction ($\hat{x}_{enc}$) en provenance du coeur DPCM de codeur (D1), et

un additionneur (ADD12) pour additionner la prédiction mise en correspondance m ($\hat{x}_{enc}$) et l'erreur de prédiction écrêtée ($e_{enc}$) $_c$, et ensuite pour reporter le résultat de l'addition, obtenant ainsi un échantillon comprimé de transport (CTS),

et **en ce que**

le coeur DPCM de codeur (D1) comprend un moyen pour écrêter les erreurs de prédiction à une plage inférieure à $2^{(N-C)}$ - 1, et/ou

le dispositif de mise en correspondance de prédiction (PM1) comprend un moyen pour une mise en correspondance non uniforme.

**19.** Appareil d'émission selon l'une quelconque des revendications 16, 17 ou 18, **caractérisé en ce qu'**il comprend également :

- une boucle à phase asservie (PLL1) qui évalue la phase $(\Phi_{enc})$ de la porteuse FI du signal FI de télévision numérique, en se basant sur un signal FI de télévision localement décodé ($\tilde{x}_{enc}$) en provenance du coeur DPCM de codeur (D1),
- un dispositif d'évaluation de luminance (LUE1) qui évalue la luminance du signal vidéo contenu dans le signal FI de télévision numérique, en se basant sur le signal FI de télévision décodée ($\tilde{x}_{enc}$) et sur la phase évaluée $(\Phi_{enc})$ de la porteuse FI, aboutissant à une luminance évaluée $(L_{enc})$, et
- un dispositif d'évaluation de décalage (SHE1) qui évalue un décalage $(sh_{enc})$, en se basant sur la phase évaluée $(\Phi_{enc})$ de la porteuse FI et sur la luminance évaluée $(L_{enc})$,

et **en ce que** le coeur DPCM de codeur comprend un moyen pour écrêter l'erreur de prédiction ($e_{enc}$) à une plage qui est décalée d'un décalage $(sh_{enc})$.

**20.** Appareil d'émission pour transformer un signal FI de télévision numérique en un flot binaire de canal de transport (TCBS) pour la transmission dudit signal FI de télévision numérique en provenance d'un premier emplacement (FL) vers un ou plusieurs seconds emplacements (SL), comprenant :

un coeur DPCM de codeur (D1) pour la compression d'un échantillon (S1) du premier signal FI de télévision numérique, représenté par N bits, en un échantillon comprimé de transport (CTS) de N - C bits, produisant une prédiction $(\hat{x}_{enc})$ et une erreur de prédiction écrêtée $(e_{enc})_c$, et

une sortie pour le flot binaire de canal de transport (TCBS),

**caractérisé en ce qu'**il comprend en outre :

une boucle à phase asservie (PLL1) pour évaluer la phase $(\Phi_{enc})$ de la porteuse FI du signal FI de télévision numérique, en se basant sur un signal FI de télévision localement décodé ($\tilde{x}_{enc}$) en provenance du coeur DPCM de codeur (D1),

un dispositif d'évaluation de luminance (LUE1) pour évaluer la luminance du signal vidéo contenu dans le signal FI de télévision numérique, en se basant sur le signal FI de télévision décodé ($\tilde{x}_{enc}$) et sur la phase évaluée $(\Phi_{enc})$ de la porteuse FI, aboutissant à une luminance évaluée $(L_{enc})$, et

un dispositif d'évaluation de décalage (SHE1) pour évaluer un décalage $(sh_{enc})$, en se basant sur la phase évaluée $(\Phi_{enc})$ de la porteuse FI et sur la luminance évaluée $(L_{enc})$,

et **en ce que** le coeur DPCM de codeur comprend un moyen pour écrêter l'erreur de prédiction $(e_{enc})$ à une plage qui est décalée sur un décalage $(sh_{enc})$.

**21.** Appareil de réception pour transformer un flot binaire de canal de transport (TCBS), qui contient un premier signal FI de télévision numérique représenté par des échantillons de transport composés d'au moins un échantillon comprimé de transport (CTS) de N - C bits et d'un échantillon résiduel de transport (RTS) de M - N bits et qui est émis avec un appareil selon la revendication 16, 17 ou 19, en un second signal FI de télévision numérique, comprenant :

une entrée pour le flot binaire de canal de transport (TCBS),

un coeur DPCM de décodeur (D2) pour décompresser les N - C bits d'un échantillon comprimé de transport (CTS) en N MSB d'un échantillon de sortie (S2), et

un circuit mélangeur (CB)

**caractérisé en ce qu'**il comprend en outre :

un détecteur d'écrêtage de second emplacement (BSC2) pour produire un signal de commande de substitution de bits PCM de second emplacement (SC2), indiquant ce qui doit être sélectionné en tant que M - N bits les moins significatifs de l'échantillon de sortie (S2), et un signal de signe (SGN), qui est le bit de signe de l'erreur d'écrêtage transformée transmise,

un dispositif de substitution de second emplacement (BS2) pour commuter entre les M - N LSB reçus en provenance de l'échantillon résiduel de transport (RTS) et un remplacement fixe selon le signal de commande de substitution de bits PCM de second emplacement (SC2), et

un correcteur de MSB (COR) pour ajouter à ou soustraire de la sortie du coeur DPCM de décodeur (D2) la valeur de sortie de mise en correspondance de l'échantillon de transport (RTS) reçu au moyen d'une seconde fonction, selon le signal de commande de substitution de bits PCM de second emplacement (SC2) et le signal de signe (SGN)

de sorte que le circuit mélangeur ayant un moyen pour combiner en un échantillon de sortie (S2) les N MSB d'un échantillon avec les M - N bits de l'échantillon résiduel de transport ou avec ledit remplacement fixe.

**22.** Appareil de réception selon la revendication 21, **caractérisé en ce qu'**il comprend également :

- un dispositif de mise en correspondance de prédiction (PM2) pour produire une prédiction mise en correspondance (m $(\hat{x}_{dec})$) à partir d'une prédiction de décodeur $(\hat{x}_{dec})$ en provenance du coeur DPCM de décodeur (D2), de sorte que le dispositif de mise en correspondance de prédiction (PM2) comprend un moyen pour une mise en correspondance non uniforme, et

- un soustracteur (SUB21) qui soustrait la prédiction mise en correspondance $(m(\hat{x}_{dec}))$ de l'échantillon du flot comprimé de transport (CTS) et qui effectue alors un report du résultat de la soustraction, obtenant ainsi une erreur de prédiction écrêtée $((e_{dec})_c)$.

**23.** Appareil de réception pour transformer un flot binaire de canal de transport (TCBS), contenant un premier signal FI de télévision numérique représenté par des échantillons de transport composés d'au moins un échantillon comprimé de transport (CTS) de N - C bits et émis avec un appareil selon la revendication 18 ou 19, en un second signal FI de télévision numérique, comprenant :

une entrée pour le flot binaire de canal de transport (TCBS),
un coeur DPCM de décodeur (D2)

**caractérisé en ce qu'**il comprend en outre :

un dispositif de mise en correspondance de prédiction (PM2) pour produire une prédiction mise en correspondance m $(\hat{x}_{dec})$ à partir d'une prédiction de décodeur $(\hat{x}_{dec})$ en provenance du coeur DPCM de décodeur (D2), de sorte que le dispositif de mise en correspondance de prédiction (PM2) comprend un moyen pour une mise en correspondance non uniforme, et

un soustracteur (SUB21) pour soustraire la prédiction mise en correspondance m $(\hat{x}_{dec})$ de l'échantillon du flot comprimé de transport (CTS) et pour le report du résultat de la soustraction, obtenant ainsi une erreur de prédiction écrêtée $(e_{dec})_c$,

de sorte que le coeur DPCM de décodeur (D2) ayant un moyen pour décompresser les N - C bits de ladite erreur de prédiction écrêtée $(e_{dec})_c$ en N bits d'un échantillon de sortie (S2).

**24.** Appareil de réception selon l'une quelconque des revendications 21, 22 ou 23, **caractérisé en ce qu'**il comprend également :

- une boucle à phase asservie (PLL2) qui évalue une phase $(\Phi_{dec})$ de la porteuse FI en se basant sur un signal FI de télévision décodé $(x_{dec})$ en provenance du coeur DPCM de décodeur (D2),

- un dispositif d'évaluation de luminance (LUE2) qui évalue la luminance du signal vidéo contenu dans le signal FI de télévision en se basant sur le signal FI de télévision décodé $(X_{dec})$ et sur ladite phase évaluée $(\Phi_{dec})$ de la porteuse FI, aboutissant à une luminance évaluée $(L_{dec})$,

- un dispositif d'évaluation de décalage (SHE2) qui évalue la quantité de décalage $(sh_{dec})$ en se basant sur ladite phase évaluée $(\Phi_{dec})$ de la porteuse FI et sur ladite luminance évaluée $(L_{dec})$,

et **en ce que** le coeur DPCM de décodeur (D2) comprend un moyen pour décoder les erreurs de prédiction qui ont été écrêtées dans le codeur au niveau de l'appareil d'émission correspondant, à une plage d'écrêtage qui a été décalée d'une quantité indiquée par un dispositif d'évaluation de décalage (SHE1) .

25. Appareil de réception pour transformer un flot binaire de canal de transport (TCBS), contenant un premier signal FI de télévision numérique représenté par des échantillons de transport composés d'au moins un échantillon comprimé de transport (CTS) de N - C bits et étant émis par un appareil selon la revendication 20, en un second signal FI de télévision numérique par un procédé correspondant au procédé de compression dudit premier signal FI de télévision numérique, comprenant :

une entrée pour le flot binaire de canal de transport (TCBS),
un coeur DPCM de décodeur (D2) pour décompresser les N - C bits d'un échantillon du flot comprimé de transport (CTS) en N bits d'un échantillon de sortie (S2),

**caractérisé en ce qu'**il comprend en outre :

une boucle à phase asservie (PLL2) pour évaluer une phase $(\Phi_{dec})$ de la porteuse FI en se basant sur un signal FI de télévision décodé $(\tilde{x}_{dec})$ en provenance du coeur DPCM de décodeur (D2),
un dispositif d'évaluation de luminance (LUE2) pour évaluer la luminance du signal vidéo contenu dans le signal FI de télévision en se basant sur le signal FI de télévision décodé $(\tilde{x}_{dec})$ et sur ladite phase évaluée $(\Phi_{dec})$ de la porteuse FI, aboutissant à une luminance évaluée $(L_{dec})$,
un dispositif d'évaluation de décalage (SHE2) pour évaluer la quantité de décalage $(sh_{dec})$ en se basant sur ladite phase évaluée $(\Phi_{dec})$ de la porteuse FI et sur ladite luminance évaluée $(L_{dec})$,
et **en ce que** le coeur DPCM de décodeur (D2) comprend un moyen pour décoder des erreurs de prédiction qui ont été écrêtées dans le codeur au niveau de l'appareil d'émission correspondant, à une plage d'écrêtage qui a été décalée d'une quantité indiquée par un dispositif d'évaluation de décalage (SHE1) .

Fig. 1

Fig. 2

Fig. 22

Fig. 3

Fig. 4

Fig. 5

Fig. 6

PRIOR ART
Fig. 7

Fig. 8

Fig. 9

$$wr((e_{enc})_c + m(\hat{x}_{enc}))$$

$$(e_{dec})_c = wr(wr((e_{enc})_c + m(\hat{x}_{enc})) - m(\hat{x}_{dec}))$$

Fig. 10

Fig. 11

Fig. 20

Fig. 12

Fig. 15

Fig. 21

Fig. 13

Fig. 14

Fig. 16

Fig. 17

Fig. 18

Fig. 19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0749237 A
- EP 0763899 A
- WO 8303727 A
- US 4791483 A

**Non-patent literature cited in the description**

- **F. VAN DE VYVER.** BARCO Lynx: Digital Optical Solution for IF Transport of Television Signals. *the Proceedings of the International TV Symposium,* 1997, 709-717
- **VAN BUUL.** Hybrid DPCM, a Combination of PCM and DPCM. *IEEE Trans. Commun.,* March 1978, vol. COM-26 (3), 362-368
- **VAN BUUL.** Hybrid DPCM, a combination of PCM and DPCM. *IEEE Transactions on Communication Technology,* March 1978, vol. COM-26 (3), 362-368